(19) Europäisches Patentamt / European Patent Office / Office européen des brevets

(11) EP 4 418 307 A1

(12) **EUROPEAN PATENT APPLICATION**
published in accordance with Art. 153(4) EPC

(43) Date of publication:
**21.08.2024 Bulletin 2024/34**

(21) Application number: **22883371.1**

(22) Date of filing: **06.10.2022**

(51) International Patent Classification (IPC):
***H01L 21/306*** *(2006.01)* ***H01L 21/304*** *(2006.01)*

(52) Cooperative Patent Classification (CPC):
**H01L 21/304; H01L 21/306**

(86) International application number:
**PCT/JP2022/037388**

(87) International publication number:
**WO 2023/068066 (27.04.2023 Gazette 2023/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.10.2021 JP 2021170993**
**13.05.2022 JP 2022079732**

(71) Applicant: **Tokyo Electron Limited**
**Tokyo 107-6325 (JP)**

(72) Inventors:
- **SAKAGUCHI, Keisuke**
**Koshi City, Kumamoto 861-1116 (JP)**
- **MARUMOTO, Hiroshi**
**Koshi City, Kumamoto 861-1116 (JP)**

(74) Representative: **Manitz Finsterwald**
**Patent- und Rechtsanwaltspartnerschaft mbB**
**Martin-Greif-Strasse 1**
**80336 München (DE)**

# (54) SUBSTRATE PROCESSING METHOD AND SUBSTRATE PROCESSING SYSTEM

(57) A substrate processing method includes determining an optimal etching condition; and etching a surface of an etching target of a substrate by supplying an etching liquid to the surface based on the optimal etching condition. The determining of the optimal etching condition includes acquiring etching index distributions in a radial direction of the etching target when the surface of the etching target is etched under multiple different etching conditions; optimizing, by using an optimization method, a combination of the etching index distributions used in superimposition and a superimposing number of the etching index distributions by superimposing the etching index distributions respectively corresponding to the multiple etching conditions such that a shape of the surface of the etching target becomes a target shape; and determining the optimal etching condition by integrating the etching conditions corresponding to the optimized combination.

*FIG. 7*

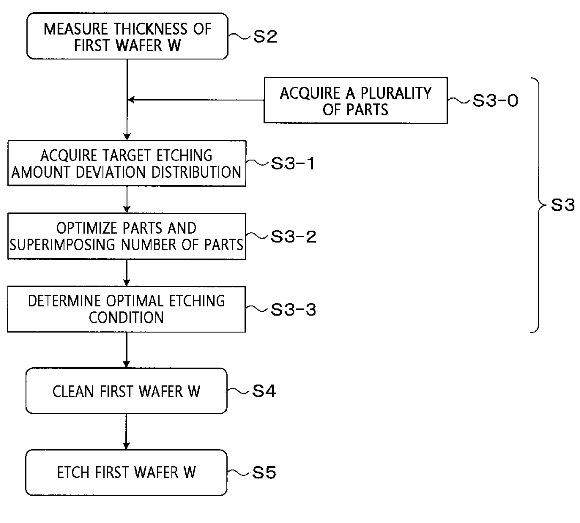


EP 4 418 307 A1

## Description

### TECHNICAL FIELD

The various aspects and embodiments described herein pertain generally to a substrate processing method and a substrate processing system.

### BACKGROUND

Patent Document 1 describes a substrate processing method including a grinding process of grinding a surface of a substrate, a measuring process of measuring a thickness of the ground substrate, a condition determining process of determining processing conditions for a wet etching to be performed on the substrate based on the measured thickness of the substrate, and an etching process of performing the wet etching by supplying a processing liquid to the ground substrate under the determined processing conditions.

### PRIOR ART DOCUMENT

Patent Document 1: Japanese Patent Laid-open Publication No. 2018-147908

### DISCLOSURE OF THE INVENTION

### PROBLEMS TO BE SOLVED BY THE INVENTION

Exemplary embodiments provide a technique capable of appropriately controlling a surface shape of an etching target after being subjected to an etching processing.

### MEANS FOR SOLVING THE PROBLEMS

In an exemplary embodiment, a substrate processing method of processing a substrate includes determining an optimal etching condition; and etching a surface of an etching target of the substrate by supplying an etching liquid to the surface based on the optimal etching condition. The determining of the optimal etching condition includes acquiring etching index distributions in a radial direction of the etching target when the surface of the etching target is etched under multiple different etching conditions; optimizing, by using an optimization method, a combination of the etching index distributions used in superimposition and a superimposing number of the etching index distributions by superimposing the etching index distributions respectively corresponding to the multiple etching conditions such that a shape of the surface of the etching target becomes a target shape; and determining the optimal etching condition by integrating the etching conditions corresponding to the optimized combination.

### EFFECT OF THE INVENTION

According to the exemplary embodiment, it is possible to appropriately control the surface shape of the etching target after being subjected to the etching processing.

### BRIEF DESCRIPTION OF THE DRAWINGS

**FIG. 1** is a graph showing etching amount deviation distributions in respective cases where a wafer is etched under a plurality of different etching conditions.
**FIG. 2** is a side view illustrating an example of a combined wafer that is processed in a wafer processing system.
**FIG. 3** is a plan view schematically illustrating a configuration of the wafer processing system according to an exemplary embodiment.
**FIG. 4** is a side view illustrating a schematic configuration of an etching apparatus.
**FIG. 5** is an explanatory diagram illustrating a nozzle being moved in a radial direction.
**FIG. 6** is a flowchart illustrating main processes of a wafer processing according to the exemplary embodiment.
**FIG. 7** is a flowchart illustrating main processes of a method of determining an optimal etching condition.
**FIG. 8** is an explanatory diagram illustrating an example of a plurality of parts.
**FIG. 9** is an explanatory diagram illustrating an example of a target etching amount deviation distribution.

**FIG. 10** is an explanatory diagram illustrating an example of parts for use in superimposition.

**FIG. 11** is an explanatory diagram illustrating an example in which a plurality of optimized parts are superimposed.

**FIG. 12** is an explanatory diagram illustrating an example of thickness deviation distributions of a first wafer after being ground and after being etched.

**FIG. 13** is an explanatory diagram illustrating an example of thickness distributions of the first wafer after being ground and after being etched.

**FIG. 14** is a plan view schematically illustrating a configuration of a wafer processing system according to another exemplary embodiment.

**FIG. 15** is a flowchart illustrating main processes of a wafer processing according to a first pattern of the another exemplary embodiment.

**FIG. 16A** to **FIG. 16D** are explanatory diagrams illustrating the main processes of the wafer processing according to the first pattern of the another exemplary embodiment.

**FIG. 17** is a flowchart illustrating main processes of a wafer processing according to a second pattern of the another exemplary embodiment.

**FIG. 18** is a flowchart illustrating main processes of a wafer processing according to a third pattern of the another exemplary embodiment.

**FIG. 19A** to **FIG. 19D** are explanatory diagrams illustrating main processes of the wafer processing according to the third pattern of the another exemplary embodiment.

## DETAILED DESCRIPTION

In a semiconductor device manufacturing process, a semiconductor substrate (hereinafter referred to as "wafer") having a plurality of devices such as electronic circuits formed on a surface thereof is ground to be thinned, and the ground surface of the wafer is smoothed. The smoothing of the ground surface is carried out through, for example, so-called spin etching in which an etching liquid is supplied from above the ground surface of the wafer while the wafer is being rotated.

It is described in the aforementioned Patent Document 1 that a damage layer formed on the surface of the wafer due to the grinding processing is removed by performing the wet etching processing on the wafer after being subjected to the grinding processing. In the condition determining process described in Patent Document 1, an operation of a nozzle configured to supply the processing liquid, a rotation speed of the wafer, a supply amount of the processing liquid, a supply time of the processing liquid, a kind of the processing liquid, and so forth are determined as conditions for the wet etching processing, based on the thickness of the wafer obtained in the measuring process.

However, when performing the spin etching by supplying the processing liquid while rotating the wafer as in the method disclosed in Patent Document 1, the processing liquid supplied to the surface of the wafer flows radially outwards due to a centrifugal force, making it difficult to perform a precise etching control. More specifically, it has been difficult to properly control a surface shape of the wafer after being etched, especially at a central portion of the wafer.

Here, the present inventors have discovered the possibility of controlling the surface shape of the wafer after being etched by acquiring etching amount deviation distributions (etching profiles) in a radial direction of the wafer when the wafer is etched under a plurality of different etching conditions (etching recipes), and then by superimposing the plurality of etching amount deviation distributions. Here, an etching amount deviation represents a value (deviation) obtained by subtracting, from etching amounts within the surface of the wafer, an average value of these etching amounts. The average value of the etching amounts is a value obtained by averaging the etching amounts within the surface of the wafer. In addition, the etching amount deviation distribution is an etching index distribution that is used as an index when controlling the etching processing of the wafer.

In this etching processing, while rotating the wafer and moving a nozzle in a radial direction through a center of the wafer, an etching liquid is supplied from the nozzle. The nozzle is reciprocated multiple times between both ends of the wafer. In the following description, the reciprocating movement of the nozzle between both ends of the wafer is referred to as one (1) loop.

**FIG. 1** is a graph showing etching amount deviation distributions in respective cases where a wafer is etched under a plurality of different etching conditions. A horizontal axis of **FIG. 1** represents a position on the wafer in a radial direction, ranging from a center (0 (zero) on the horizontal axis) of the wafer to an outer end (R on the horizontal axis) thereof, and a vertical axis represents an etching amount deviation.

Comparative Example 1 (dashed dotted line) in **FIG. 1** shows an etching amount deviation distribution when only an etching processing under Condition A, in which a rotation speed of the wafer is set to 200 rpm, is performed. Comparative Example 2 (dashed double-dotted line) shows an etching amount deviation distribution when only an etching processing under Condition B, in which the rotation speed of the wafer is set to 1000 rpm, is performed. Meanwhile, Experimental Example 1 (thick solid line) presents an etching amount deviation distribution when Condition A and Condition B are performed at a time (loop number) ratio of 1:1. A thin solid line indicates a calculated value of the etching amount deviation distribution under the etching condition of Experimental Example 1. This calculated value is obtained by adding 1/2 of the etching amount deviation distribution of Comparative Example 1 and 1/2 of the etching amount deviation distribution of Comparative Example 2. Experimental Example 2 (thick dashed line) presents an etching amount deviation distribution when Condition A and Condition B are performed at a time ratio of 5:1. A thin dashed line indicates a calculated value of the etching amount deviation distribution under the etching condition of Experimental Example 2. This calculated value is obtained by adding 5/6 of the etching amount deviation distribution of Comparative Example 1 and 1/6 of the etching amount deviation distribution of Comparative Example 2. In addition, in all of Comparative Examples 1 and 2 and Experimental Examples 1 and 2, etching conditions other than the rotation speed of the wafer are set to be the same.

In this case, as shown in **FIG. 1,** an actual measurement value of the etching amount deviation distribution of Experimental Example 1 in which Condition A and Condition B are performed at the time ratio of 1:1 is found to be substantially equal to an average value (calculated value) of the etching amount deviation distribution of Comparative Example 1 and the etching amount deviation distribution of Comparative Example 2. Further, an actual measurement value of the etching amount deviation distribution of Experimental Example 2 in which Condition A and Condition B are performed at the time ratio of 5:1 is found to be substantially equal to a proportional distribution value (calculated value) obtained by dividing the etching amount deviation distribution of Comparative Example 1 and the etching amount deviation distribution of Comparative Example 2 by the time ratio. The fact that the measured values and the calculated values are approximately same in this way indicates that the etching amount deviation distribution after the superimposition is accurate.

Further, in comparison of Experimental Example 1 and Experimental Example 2, an etching amount deviation at the center of the wafer is smaller than an etching amount deviation at a periphery of the wafer in Experimental Example 1, whereas the etching amount deviation distribution is uniform within the surface of the wafer in Experimental Example 2. In other words, it is found out that a required etching amount deviation distribution can be obtained by adjusting the time ratio.

By superimposing the etching amount deviation distributions corresponding to the plurality of etching conditions as described above, the surface shape of the wafer after being subjected to the etching processing can also be controlled by superimposition. The present invention have found out that by adjusting the time ratio (loop number ratio) for the plurality of etching conditions, the etching amount deviation distribution can be controlled to thereby control the surface shape of the wafer after being subjected to the etching processing.

In view of the foregoing, exemplary embodiments provide a technique capable of appropriately controlling a surface shape of an etching target after being subjected to an etching processing. Hereinafter, a wafer processing system as a substrate processing system and a wafer processing method as a substrate processing method according to exemplary embodiments will be described with reference to the accompanying drawings. In the present specification and the drawings, parts having substantially the same functions and configurations will be assigned same reference numerals, and redundant description thereof will be omitted.

In a wafer processing system 1 to be described later according to an exemplary embodiment, a processing is performed on a combined wafer T as a substrate in which a first wafer W and a second wafer S are bonded to each other as shown in **FIG. 2**. Hereinafter, in the first wafer W, a surface to be bonded to the second wafer S is referred to as a front surface Wa, and a surface opposite to the front surface Wa is referred to as a rear surface Wb. Likewise, in the second wafer S, a surface to be bonded to the first wafer W is referred to as a front surface Sa, and a surface opposite to the front surface Sa is referred to as a rear surface Sb.

The first wafer W is, for example, a semiconductor wafer such as a silicon substrate, and a device layer Dw including a plurality of devices is formed on the front surface Wa of the first wafer W. Further, a bonding film Fw is formed on the device layer Dw, and the first wafer W is bonded to the second wafer S with the bonding film Fw therebetween. An oxide film (a THOX film, a $SiO_2$ film, a TEOS film), a SiC film, a SiCN film, or an adhesive is used as an example of the bonding film Fw.

The second wafer S has the same structure as the first wafer W, for example, and a device layer Ds and a bonding film Fs are formed on the front surface Sa of the second wafer S. However, the second wafer S does not need to be a device wafer on which the device layer Ds is formed, and it may be, for example, a support wafer that supports the first wafer W. In this case, the second wafer S functions as a protective member that protects the device layer Dw of the first wafer W.

As illustrated in **FIG. 3**, the wafer processing system 1 has a configuration in which a carry-in/out station 2 and a processing station 3 are connected as one body. In the carry-in/out station 2, a cassette C capable of accommodating therein a plurality of combined wafers T is carried to/from the outside, for example. The processing station 3 is equipped with various types of processing apparatuses configured to perform required processings on the combined wafer T.

The carry-in/out station 2 is equipped with a cassette placing table 10 on which a plurality of, *e.g.*, three cassettes C are placed thereon. Further, a wafer transfer device 20 is provided adjacent to the cassette placing table 10 on the negative X-axis side of the cassette placing table 10. The wafer transfer device 20 is configured to be movable on a transfer path 21 extending in the Y-axis direction. Further, the wafer transfer device 20 has, for example, two transfer arms 22 each configured to hold and transfer the combined wafer T. Each transfer arm 22 is configured to be movable in a horizontal direction and a vertical direction and pivotable around a horizontal axis and a vertical axis. Furthermore, the configuration of the transfer arm 22 is not limited to that of the present exemplary embodiment, and the transfer arm 22 may have any of various configurations. In addition, the wafer transfer device 20 is configured to be capable of transferring the combined wafer T to/from the cassette C on the cassette placing table 10 and a transition device 30 to be described later.

In the carry-in/out station 2, the transition device 30 configured to deliver the combined wafer T to/from the processing station 3 is provided adjacent to the wafer transfer device 20 on the negative X-axis side of the wafer transfer device 20.

The processing station 3 is provided with, for example, three processing blocks B1 to B3. The first processing block B1, the second processing block B2, and the third processing block B3 are arranged in this order from the positive X-axis side (carry-in/out station 2 side) toward the negative X-axis side.

The first processing block B1 is equipped with an etching apparatus 40, a thickness measuring apparatus 41, and a wafer transfer device 50. The etching apparatus 40 and the thickness measuring apparatus 41 are stacked on top of each other. Here, the number and the layout of the etching apparatus 40 and the thickness measuring apparatus 41 are not limited to the shown example.

The etching apparatus 40 is configured to etch the rear surface Wb (ground surface) of the first wafer W after being subjected to grinding in a processing apparatus 80 to be described later, further thin the first wafer W (combined wafer T) after being subjected to the grinding, and smooth the ground surface by removing a grinding mark caused by the grinding processing. A detailed configuration of the etching apparatus 40 will be described later.

The thickness measuring apparatus 41 includes, as an example, a measurer (not shown) and a calculator (not shown). The measurer is provided with a sensor configured to measure the thickness of the first wafer W after being etched at multiple points. The calculator acquires a thickness distribution of the first wafer W from a measurement result (thickness of the first wafer W) obtained by the measurer, and also calculates flatness (TTV: Total Thickness Variation) of the first wafer W. Further, the calculation of the thickness distribution and the flatness of the first wafer W may be performed by a control device 90 to be described later instead of the calculator. In other words, the calculator (not shown) may be provided in the control device 90 to be described later. Additionally, the configuration of the thickness measuring apparatus 41 is not limited to the shown example, and various other configurations may be adopted.

The wafer transfer device 50 is disposed on the negative X-axis side of the transition device 30. The wafer transfer device 50 has, for example, two transfer arms 51 each configured to hold and transfer the combined wafer T. Each transfer arm 51 is configured to be movable in a horizontal direction and a vertical direction and pivotable around a horizontal axis and a vertical axis. The wafer transfer device 50 is configured to be capable of transferring the combined wafer T to/from the transition device 30, the etching apparatus 40, the thickness measuring apparatus 41, a cleaning apparatus 60 to be described later, a thickness measuring apparatus 61 to be described later, and a buffer apparatus 62 to be described later.

The second processing block B2 is provided with the cleaning apparatus 60, the thickness measuring apparatus 61, the buffer apparatus 62, and a wafer transfer device 70. The cleaning apparatus 60, the thickness measuring apparatus 61, and the buffer apparatus 62 are stacked on top of each other. Here, the number and the layout of the cleaning apparatus 60, the thickness measuring apparatus 61, and the buffer apparatus 62 are not limited to the shown example.

The cleaning apparatus 60 is configured to clean the rear surface Wb (ground surface) of the first wafer W after being subjected to the grinding in the processing apparatus 80 to be described later. For example, a brush is brought into contact with the rear surface Wb to clean the rear surface Wb. Further, a pressurized cleaning liquid may be used to clean the first wafer W. Additionally, the cleaning apparatus 60 may be configured to be capable of cleaning the rear surface Sb of the second wafer S concurrently when cleaning the first wafer W.

The thickness measuring apparatus 61 includes, as an example, a measurer (not shown) and a calculator (not shown). The measurer is provided with a sensor configured to measure the thickness of the first wafer W after being ground at multiple points. The calculator acquires a thickness distribution of the first wafer W from a measurement result (thickness of the first wafer W) obtained by the measurer, and also calculates flatness (TTV: Total Thickness Variation) of the first wafer W. Further, the calculation of the thickness distribution and the flatness of the first wafer W may be performed by the control device 90 to be described later instead of the calculator. In other words, the calculator (not shown) may be provided in the control device 90 to be described later. Additionally, the configuration of the thickness measuring apparatus 61 is not limited to the shown example, and various other configurations may be adopted.

The buffer apparatus 62 is configured to temporarily hold the combined wafer T before being processed which is transferred from the first processing block B1 to the second processing block B2. The configuration of the buffer apparatus 62 is not particularly limited. Further, the buffer apparatus 62 may include an alignment mechanism (not shown) configured to adjust a center position of the combined wafer T with respect to a chuck 83 to be described later, and/or a direction of the combined wafer T in a horizontal direction.

The wafer transfer device 70 is disposed on the positive Y-axis side of the cleaning apparatus 60, the thickness measuring apparatus 61, and the buffer apparatus 62, for example. The wafer transfer device 70 has, for example, two transfer arms 71 each configured to transfer the combined wafer T by attracting and holding the combined wafer T on a non-illustrated attracting/holding surface thereof. Each transfer arm 71 is supported by a multi-joint arm member 72, and is configured to be movable in a horizontal direction and a vertical direction and pivotable around a horizontal axis and a vertical axis. This wafer transfer device 70 is configured to be capable of transferring the combined wafer T to/from the etching apparatus 40, the thickness measuring apparatus 41, the cleaning apparatus 60, the thickness measuring apparatus 61, the buffer apparatus 62, and the processing apparatus 80 to be described later.

The third processing block B3 is equipped with the processing apparatus 80. The processing apparatus 80 is configured to grind the first wafer W to thin it, and functions as a thinning device in the present disclosure.

The processing apparatus 80 has a rotary table 81. The rotary table 81 is configured to be rotatable about a vertical rotation center line 82 by a rotating mechanism (not shown). Provided on the rotary table 81 are two chucks 83 each configured to attract and hold the combined wafer T. The chucks 83 are evenly arranged on the same circumference as the rotary table 81. The two chucks 83 are configured to be movable to a delivery position A0 and a processing position A1 as the rotary table 81 is rotated. Further, each of the two chucks 83 is configured to be rotatable around a vertical axis by a rotating mechanism (not shown).

A delivery of the combined wafer T is performed at the delivery position A0. A grinding device 84 is disposed at the processing position A1 to grind the first wafer W while attracting and holding the second wafer S with the chuck 83. The grinding device 84 has a grinder 85 equipped with a grinding whetstone (not shown) configured to be rotatable in an annular shape. Further, the grinder 85 is configured to be movable in a vertical direction along a supporting column 86.

Additionally, the configuration of the processing apparatus 80 is not limited to the shown example. By way of example, four chucks 83 may be provided on the rotary table 81, and these four chucks 83 may be configured to be movable between a delivery position of the combined wafer T, a rough grinder (not shown) configured to perform rough grinding of the first wafer W, an intermediate grinder (not shown) configured to perform intermediate grinding of the first wafer W, and a finishing grinder (not shown) configured to perform finishing grinding of the first wafer W. In addition, the processing apparatus 80 may be equipped with a thickness measurer (not shown) configured to measure the thickness of the first wafer W after being ground at multiple points.

The wafer processing system 1 described above is provided with the control device 90. The control device 90 is, for example, a computer equipped with a CPU, a memory, and the like, and has a program storage (not shown). The program storage stores therein a program for controlling the processing of the combined wafer T in the wafer processing system 1. The program may have been recorded on a computer-readable recording medium H, and may be installed from the recording medium H into the control device 90. Further, the recording medium H may be transitory or non-transitory.

Now, the configuration of the etching apparatus 40 will be explained. As depicted in **FIG. 4**, the etching apparatus 40 includes a wafer holder 100 as a substrate holder, a rotating mechanism 101, and a nozzle 102 as an etching liquid supply.

The wafer holder 100 is configured to hold an edge of the combined wafer T at multiple points, for example, three points in the present exemplary embodiment. Here, however, the configuration of the wafer holder 100 is not limited to the shown example. For instance, the wafer holder 100 may be provided with a chuck configured to attract and hold the combined wafer T from below. The rotating mechanism 101 is configured to rotate the combined wafer T (first wafer W) held by the wafer holder 100 about a vertical rotation center line 100a.

The nozzle 102 is configured to supply an etching liquid E to the rear surface Wb of the first wafer W held by the wafer holder 100. The nozzle 102 is connected to an etching liquid source (not shown) that supplies the etching liquid E to the nozzle 102. The nozzle 102 is provided above the wafer holder 100, and is configured to be movable in a horizontal direction and a vertical direction by a moving mechanism 103. As an example, the nozzle 102 is configured to be capable of making a reciprocating movement (scanning movement) while passing through the rotation center line 100a of the wafer holder 100, that is, above a central portion of the first wafer W as shown in **FIG. 5.**

The etching liquid E contains at least hydrofluoric acid or nitric acid to properly etch the silicon of the first wafer W, which can be an etching target. Further, the etching liquid E may contain phosphoric acid or sulfuric acid. Additionally, the etching target is not limited to the first wafer W, and it may be, for example, amorphous silicon. Further, the etching target of the present exemplary embodiment is not limited to the rear surface Wb of the first wafer W. By way of example, the present exemplary embodiment is applicable even to a case of processing a wafer which is not processed by the processing apparatus 80. For example, if a film is formed on the rear surface Wb, this film can be an etching target.

Now, a wafer processing performed by using the wafer processing system 1 configured as above will be described. In the present exemplary embodiment, the combined wafer T is previously formed in a bonding apparatus (not shown) outside the wafer processing system 1. Further, a peripheral portion of the first wafer W ranging from, for example, 0.5 mm to 3 mm from an outer end of the first wafer W in the radial direction may be removed in advance.

First, the cassette C accommodating therein a plurality of combined wafers T is placed on the cassette placing table 10 of the carry-in/out station 2. Then, the combined wafer T in the cassette C is taken out by the wafer transfer device 20 and transferred to the transition device 30. The combined wafer T transferred to the transition device 30 is then transferred to the buffer apparatus 62 by the wafer transfer device 50. In the buffer apparatus 62, the center position of the combined wafer T with respect to the chuck 83 and/or the direction of the combined wafer T in the horizontal direction may be adjusted.

Subsequently, the combined wafer T is transferred to the processing apparatus 80 by the wafer transfer device 70, and delivered to the chuck 83 at the delivery position A0. The rear surface Sb of the second wafer S is attracted to and held by the chuck 83. Next, the chuck 83 is moved to the processing position A1, and the rear surface Wb of the first wafer W is ground by the grinding device 84. By this grinding processing, the thickness of the first wafer W (combined wafer T) is reduced to a required grinding target thickness (process S1 in **FIG. 6**).

Next, the combined wafer T is transferred to the thickness measuring apparatus 61 by the wafer transfer device 70. In the thickness measuring apparatus 61, the thickness of the first wafer W (combined wafer T) after being ground is measured at multiple points to obtain a thickness distribution of the first wafer W after being ground, and, also, flatness of the first wafer W is calculated (process S2 in **FIG. 6**). The thickness distribution and the flatness of the first wafer W thus calculated are outputted to, for example, the control device 90. When the processing apparatus 80 is provided with a thickness measuring device, the thickness of the first wafer W after being ground may be measured by the thickness measuring device of the processing apparatus 80.

The control device 90 determines an optimal etching condition for a subsequent etching processing from the received thickness distribution and flatness of the first wafer W (process S3 in **FIG. 6**). A detailed method of determining the optimal etching condition in the control device 90 will be described later.

The combined wafer T in which the thickness of the first wafer W has been measured is then transferred to the cleaning apparatus 60 by the wafer transfer device 70 or the wafer transfer device 50. In the cleaning apparatus 60, the rear surface Wb, which is the ground surface of the first wafer W after being ground, is cleaned (process S4 in **FIG. 6**). Additionally, in the cleaning apparatus 60, the rear surface Sb of the second wafer S may be cleaned as stated above. In addition, when measuring the thickness after the grinding in the thickness measuring apparatus 61 as in the present exemplary embodiment, the order of the processes S2, S3, and the process S4 may be reversed. That is, after cleaning the rear surface Wb of the first wafer W in the cleaning apparatus 60, the thickness of the first wafer W may be measured in the thickness measuring apparatus 61 to determine the optimal etching condition for an etching processing.

Next, the combined wafer T is transferred to the etching apparatus 40 by the wafer transfer device 50. In the etching apparatus 40, the rear surface Wb, which is the ground surface of the first wafer W, is etched by the etching liquid E under the optimal etching condition (process S5 in **FIG. 6**).

In the etching of the first wafer W, the wafer holder 100 (the first wafer W) is first rotated about the vertical rotation center line 100a, and the supply (discharge) of the etching liquid E from the nozzle 102 is begun to start the etching of the rear surface Wb.

In the etching of the first wafer W, while carrying on the supply of the etching liquid E from the nozzle 102, the nozzle 102 is reciprocated (scanned) so as to pass through a position above a rotation center of the first wafer W, that is, the rotation center line 100a, with the rotation center line 100a as a midpoint, as shown in **FIG. 5**. A detailed method of determining the etching conditions, such as a rotation speed of the first wafer W, a scan width of the nozzle 102, and a scan speed when reciprocating the nozzle 102, will be described later.

Upon the completion of the etching of the rear surface Wb under the optimal etching condition, the supply of the etching liquid E from the nozzle 102 is stopped, and the rear surface Wb of the first wafer W is rinsed with pure water and is then dried by being shaken. Thereafter, the rotation of the wafer holder 100 (the first wafer W) is stopped, and the etching of the first wafer W is ended.

Here, the optimal etching condition for the first wafer W is determined based on the thickness distribution and the flatness of the first wafer W after being ground as described above. Specifically, the optical etching condition is determined based on a difference between the actual measurement values of the thickness distribution and the flatness of the first wafer W in the thickness measuring apparatus 61 and a thickness distribution and a flatness in a target surface shape (hereinafter, referred to as "target shape") of the first wafer W after being etched. Then, in the process S5, the first wafer W is etched under the optimal etching condition, so that the difference between the actual measurement values and the target values of the thickness of the first wafer W is removed by the etching, and the first wafer W is processed into the target shape. Therefore, according to the present exemplary embodiment, the target surface shape of the first wafer W can be obtained appropriately, regardless of the surface shape of the first wafer W after being ground.

Next, the combined wafer T is transferred to the thickness measuring apparatus 41 by the wafer transfer device 50. In the thickness measuring apparatus 41, the thickness of the first wafer W (combined wafer T) after being etched is measured at multiple points to acquire a thickness distribution of the first wafer W after being etched (process S6 in **FIG. 6**). Further, the flatness of the first wafer W may also be calculated. The calculated thickness distribution of the first wafer W is outputted to, for example, the control device 90 to be used to process another combined wafer T to be processed next in the wafer processing system 1, for example. Furthermore, in case that the thickness of the first wafer W after being ground is measured in the thickness measuring device of the processing apparatus 80, the thickness of the first wafer W after being etched may be measured in the thickness measuring apparatus 61.

Afterwards, the combined wafer T after being subjected to all the required processes is transferred to the cassette C of the cassette placing table 10 via the transition device 30. In this way, the series of processes of the wafer processing in the wafer processing system 1 are completed.

Now, the detailed method of determining the aforementioned optimal etching condition (process S3 in **FIG. 6**) will be discussed.

First, in determining the optimal etching condition, a plurality of parts to be used in an optimization processing to be described later are acquired (process S3-0 in **FIG. 7**) prior to the processing on the combined wafer T in the wafer processing system 1. Here, the part refers to an etching amount deviation distribution of the first wafer W for a certain etching condition.

In the process S3-0, etching is performed on dummy wafers under a plurality of different etching conditions, for example. As a specific example, the dummy wafers are etched while changing the rotation speed of the dummy wafers, the scan speed of the nozzle 102, the scan width (see scan width L in **FIG. 5**) of the nozzle 102, or the like during the etching. At this time, a processing time for the etching of each dummy wafer is the same. The etching of the dummy wafer is performed by supplying the etching liquid E to the dummy wafer from the nozzle 102 while rotating the dummy wafer and reciprocating the nozzle 102, the same as in the etching in the process S5. In the following description, a reciprocating movement of the nozzle 102 between both ends of the dummy wafer is referred to as one loop.

The etching of the dummy wafers under the respective etching conditions is performed for a predetermined required time (required loop number). Then, an etching amount deviation distribution of the dummy wafers is acquired, and this etching amount deviation distribution is outputted to the control device 90. Further, in the control device 90, the received etching amount deviation distributions under the respective etching conditions are compressed into etching amount deviation distributions in unit time (unit loop number), and each of the compressed etching amount deviation distributions is stored as the part.

**FIG. 8** shows an example of the plurality of parts. A horizontal axis of **FIG. 8** represents a position in a radial direction, ranging from a center (0 (zero) on the horizontal axis) of the wafer to an outer end (±R on the horizontal axis) thereof, and a vertical axis represents an etching amount deviation. The example shown in **FIG. 8** shows a case where a total of 36 types of parts are stored in the control device 90, in other words, a case where the etching amount deviation distribution is acquired under a total of 36 types of different etching conditions.

Further, although the unit time (unit loop number) can be set as required depending on the purpose, it is desirable that the unit time (unit loop number) is short in order to obtain an appropriate target etching amount deviation distribution in the superimposition of the parts to described later. As an example, the unit time of the parts stored in the control device 90 is a time of 1 loop (one round trip of the scan width L shown in **FIG. 5**), preferably a time of 0.5 loop (half round trip of the scan width L shown in **FIG. 5**).

In addition, although the above description has provided for the example of acquiring the parts by the etching of the dummy wafer, the etching target when acquiring the parts is not limited to the dummy wafer. Specifically, an etching result of the first wafer W actually processed in the wafer processing system 1 may be stored as the part, for example. As another example, when a film is formed on the rear surface Wb of the first wafer W, the etching target may be the film, and an etching result of the film may be stored as the part.

In the wafer processing in the wafer processing system 1 according to the present disclosure, the optimal etching condition is determined by using the plurality of parts (**FIG. 8**) obtained in this way.

First, based on the thickness distribution in the target shape of the first wafer W after being etched and the thickness distribution in the surface shape (hereinafter referred to as "actual shape") of the first wafer W after being ground, which is acquired in the process S2, a target etching amount deviation distribution in the etching processing of the above-described process S5 is acquired (process S3-1 in **FIG. 7**). As an example, the target etching amount deviation distribution of the etching processing can be acquired by calculating a difference between the thickness distribution of the target shape of the first wafer W and the thickness distribution of the actual shape of the first wafer W.

**FIG. 9** presents an example of the target etching amount deviation distribution. In this example, the target etching amount deviation distribution is V-shaped. However, the shape of the target etching amount deviation distribution is not limited to the V-shape. That is, based on the difference between the thickness distribution of the target shape of the first wafer W and the thickness distribution of the actual shape, the target etching amount deviation distribution may have any of various shapes such as a V-shape, an A-shape, an M-shape, a W-shape, and so forth.

Next, in order to acquire the target etching amount deviation distribution obtained in the process S3-1 by superimposing a plurality of parts, the parts used in this superimposition and the superimposing number of the parts are optimized by using an optimization method (process SS3-2 in **FIG. 7**).

In the process S3-2, the parts and the superimposing number of the parts are optimized by applying a control of the etching amount deviation distribution to, for example, a knapsack problem. By way of example, the etching amount deviation distribution is a knapsack of the knapsack problem, and the parts are items of the knapsack problem. Then, the parts and the superimposing number of the parts are optimized such that a difference between a superimposed etching amount deviation distribution and the target etching amount deviation distribution is minimized.

As an example of this optimization method, a genetic algorithm or a dynamic programming method may be used. Then, by executing optimization calculation, one or more parts to be used for the superimposition are selected as shown in **FIG. 10** from the plurality of parts shown in **FIG. 8,** and the selected parts are superimposed as shown in **FIG. 11**. Then, the superimposed etching amount deviation distribution (solid line in **FIG. 11**) approximates the target etching amount deviation distribution (dashed line in **FIG. 11**).

In addition, in this optimization calculation, the parts and the superimposing number of the parts are optimized such that the supply time of the etching liquid E from the nozzle 102 to the first wafer W in the etching processing is minimized. As described above, in the present exemplary embodiment, so-called multi-purpose optimization is performed in which both the etching amount deviation distribution, that is, etching precision, and the supply time of the etching liquid E are optimized. To elaborate, the parts and the superimposing number of the parts are optimized by using the following Expression 1. Here, the etching precision refers to precision of the etching amount deviation distribution within the surface of the wafer.

[Expression 1]

$$Min\begin{Bmatrix}\alpha \cdot TTV + (1-\alpha) \cdot RMSE_{centerized} \\ t_{dispense}\end{Bmatrix} s.t.\ t_{dispense} \leq 50 \quad \cdots (1)$$

Here, $\alpha$ denotes a coefficient ranging from 0 (zero) to 1; TTV, flatness of the actual shape; $RMSE_{centerized}$, non-uniformity of the thickness distribution of the wafer; $t_{dispense}$, a supply time of the etching liquid E.

In the process S3-2, a loss function of the etching amount deviation distribution (etching precision) is calculated as a weighted linear sum of the flatness of the actual shape and the non-uniformity of the thickness distribution of the actual shape, as indicated by Expression 1. For example, when the coefficient $\alpha$ is 0.5 in Expression 1, the flatness (TTV) and the non-uniformity (RMSE) of the thickness distribution have the same importance. Meanwhile, when the coefficient $\alpha$ is 1, for example, it becomes an algorithm that emphasizes the flatness, whereas when the coefficient $\alpha$ is 0 (zero), it becomes an algorithm that emphasizes the non-uniformity of the thickness distribution.

In the process S3-2, to optimize the superimposing number of the parts, the superimposing number may be optimized in the unit of 0.5 loop. In this case, it becomes possible to start the supply of the etching liquid E from the center of the first wafer W and end it at the center as well, for example.

Once the parts and the superimposing number of the parts are optimized as described above, etching conditions corresponding to the parts optimized in the process S3-2 are integrated to determine the optimal etching condition (process S3-3 in **FIG. 7**). Specifically, the optimal etching condition is determined by integrating multiple etching conditions such that the selected multiple etching conditions are performed with the optimized superimposing number. In other words, the optimal etching condition capable of optimizing the etching amount deviation distribution is determined.

Thereafter, the rear surface Wb of the first wafer W is cleaned in the process S4, and then, the rear surface Wb of the first wafer W is etched under the optimal etching condition in the process S5. That is, in the etching apparatus 40, the combined wafer T (first wafer W) is rotated at a rotation speed determined according to the optimal etching condition, and the etching liquid E is supplied to the first wafer W while moving the nozzle 102 at a scan speed and a scan width determined according to the optimal etching condition.

Determination of the optimal etching condition and the etching processing on the first wafer W based on the optimal etching condition are performed as described above.

According to the above-described exemplary embodiment, since the optimal etching condition is determined by optimizing the parts to be superimposed and the superimposing number of the parts through the optimization method in the process S3, the first wafer W can be then etched under the determined optimal etching condition in the process S5. As a result, the etching amount deviation distribution in the etching processing can be optimized to approach the target etching amount deviation distribution, and, therefore, the surface shape of the first wafer W after being etched can be set into the target shape. In other words, the optimal etching condition can be determined from any etching conditions, so that the surface shape of the first wafer W after being etched can be appropriately controlled.

In fact, the present inventors have performed simulations and found out that the non-uniformity of the thickness distribution of the first wafer W after being etched can be set within an allowable range regardless of whether the target etching amount deviation distribution has the V-shape, the A-shape, the M-shape, or the W-shape. In addition, the flatness (TTV) of the first wafer W after being etched has been found to be improved as compared to the conventional cases.

Moreover, since the processes S1 to S6 are performed for every single sheet of combined wafer T, the surface shape of the first wafer W after being etched can be controlled sheet by sheet.

In the above-described exemplary embodiment, the rotation speed of the first wafer W, the scan width of the nozzle 102, and the scan speed of the nozzle 102 are used as variables for the etching condition. However, the variables for the etching condition are not limited thereto. For example, the type, viscosity, temperature, and supply amount of the etching liquid E may be used as variables for the etching condition. In this case, in the process S3-0, the plurality of parts, for which the type, viscosity, temperature, and supply amount of the etching liquid E are changed, are acquired. Then, by performing the processes S3-1 to S3-3, the optimal etching condition is determined.

The above exemplary embodiment has been described for the example where various processings are performed on the rear surface Wb of the first wafer W in the combined wafer T in which the first wafer W and the second wafer S are bonded to each other. However, the processing target is not limited thereto. By way of example, a thinning processing or an etching processing may be performed on a single sheet of wafer alone. The processing target may be a film formed on the surface of the wafer, for example, an oxide film or titanium nitride. In this case, the nozzle 102 in the etching apparatus 40 may be configured to switch the supply of different types of etching liquids E depending on the etching target. Further, when a film formed on the surface of a wafer is an etching target, for example, an etching result of the corresponding film may be stored as the parts. In the thickness measuring apparatus 61, the thickness of the film is measured. Additionally, when a protective tape is attached on a device surface of the wafer, a thinning processing or an etching processing may be performed on a surface of the wafer opposite to where the protective tape is provided. Furthermore, a thinning processing or an etching processing may be performed on the wafer cut out from an ingot with a wire saw or the like and lapped. The etching processing can be performed for any of the various processing targets under the optimal etching condition of the above-described exemplary embodiment.

Further, when a film is formed on the rear surface Wb of the first wafer, for example, this film may be an etching target. In this case, the thickness measuring apparatus 61 measures the thickness of the film, for example. That is, in the process S2, the thickness of the film is measured instead of the thickness of the first wafer W, and, further, a thickness distribution of the film and flatness of the film are measured. Then, in the process S3, the optimal etching condition is determined based on the calculated thickness distribution and flatness of the film.

In addition, although the wafer processing system 1 is equipped with the various apparatuses other than the etching apparatus 40, the apparatus configuration to which the present disclosure is applied is not limited thereto. By way of example, the processing apparatus 80, which is the thinning device, may be omitted. In this case, the etching target is not limited to the wafer after being subjected to the thinning processing. Further, the technique of the present disclosure can also be applied to a case of etching the wafer in an etching apparatus alone.

In the above-described exemplary embodiment, the first wafer W is thinned in the processing apparatus 80. However, the thinning method is not limited thereto. For example, the thinning processing of the first wafer W includes polishing of the rear surface Wb of the first wafer W as well. Alternatively, the first wafer W may be thinned by being separated starting from a modification layer (not shown) formed inside the first wafer W by a laser processing. In this case, the wafer processing system 1 is provided with, instead of the processing apparatus 80, a laser processing apparatus (not shown) configured to form the modification layer (not shown).

In the above-described exemplary embodiment, the etching amount deviation distribution (distribution of values obtained by subtracting, from etching amounts within the surface of the wafer, an average of these etching amounts) is used as an etching index distribution for controlling the etching processing of the rear surface Wb of the first wafer W. Alternatively, however, a distribution of the etching amounts (absolute values) may be used. Specifically, when determining the optimal etching condition in the process S3, the etching amount distribution is optimized instead of optimizing the etching amount deviation distribution.

In the process S3-0, a plurality of parts of the etching amount distribution is acquired. An example of the plurality of parts may be parts in which a vertical axis represents an etching amount.

In the process S3-1, a target etching amount distribution in the etching processing in the process S5 is obtained based on the thickness distribution in the target shape of the first wafer W after being etched and the thickness distribution in the actual shape of the first wafer W after being ground, which is acquired in the process S2. The target etching amount distribution is an etching amount distribution in which a vertical axis in **FIG. 9** represents an etching amount.

In the process S3-2, in order to acquire the target etching amount distribution in the process S3-1 by superimposing a plurality of parts, the parts to be used for the superimposition and the superimposing number of the parts are optimized by using an optimization method. At this time, an example of the parts for use in the superimposition are parts in which a vertical axis in **FIG. 10** represents an etching amount. An example of the superimposed etching amount distribution is one indicated by a solid line in which a vertical axis in **FIG. 11** represents an etching amount.

In the process S3-3, by integrating etching conditions corresponding to the parts optimized in the process S3-2, an optimal etching condition is determined. In other words, the optimal etching condition capable of optimizing the etching amount distribution on the rear surface Wb is determined.

Detailed methods of the respective processes S3-0 to S3-3 are the same as the methods of the processes S3-0 to S3-3 of the above-described exemplary embodiment, except for input data. That is, while the input data in the above-described exemplary embodiment is the plurality of parts of the etching amount deviation distribution and the target etching amount deviation distribution, the input data in the present exemplary embodiment is the plurality of parts of the etching amount distribution and the target etching amount distribution.

Here, if the etching amount deviation distribution is optimized as in the above-described exemplary embodiment, the shape (profile) of the rear surface Wb of the first wafer W after being etched can be controlled with precision. Meanwhile, if the etching amount is optimized as in the present exemplary embodiment, the shape of the rear surface Wb of the first wafer W after being etched can be precisely controlled, and, also, the thickness of the first wafer W can be controlled precisely.

**FIG. 12** shows an example of thickness deviation distributions (distributions of values obtained by subtracting, from the thicknesses of the wafer within the surface thereof, the average of these thicknesses) of the first wafer W after being ground and after being etched, respectively. A horizontal axis in **FIG. 12** represents a position in a radial direction, ranging from a center (0 (zero) on the horizontal axis) of the wafer to an outer end (±R on the horizontal axis) thereof, and a vertical axis indicates a thickness deviation distribution of the first wafer W. Comparing the thickness deviation distribution (indicated by a dashed line in **FIG. 12)** of the first wafer W after being ground with the thickness deviation distribution (indicated by a solid line in **FIG. 12**) of the first wafer W after being etched according to the present exemplary embodiment, the flatness (TTV) of the first wafer W is found to be improved after the etching. Therefore, according to the present exemplary embodiment, the flatness (TTV) of the first wafer W can be improved by the etching, so that the shape of the rear surface Wb can be controlled precisely.

**FIG. 13** shows an example of thickness distributions of the first wafer W after being ground and after being etched, respectively. A horizontal axis in **FIG. 13** represents a position in a radial direction, ranging from a center (0 (zero) on the horizontal axis) of the wafer to an outer end (±R on the horizontal axis) thereof, and a vertical axis represents a thickness distribution of the first wafer W. Comparing the thickness distribution (indicated by a dashed line in **FIG. 13**) of the first wafer W after being ground with the thickness distribution (indicated by a solid line in **FIG. 12**) of the first wafer W after being etched according to the present exemplary embodiment, the thickness of the first wafer W can be uniformed to an average of the thicknesses within the surface of the wafer (a value obtained by averaging the thicknesses within the surface of the wafer) after the etching. Therefore, according to the present exemplary embodiment, the thickness of the first wafer W of the first wafer W can be precisely controlled by the etching.

In addition, the shape of the rear surface Wb of the first wafer W can be controlled more precisely based on the etching amount deviation distribution rather than the etching amount. For this reason, when it is required to control the shape of the rear surface Wb more precisely, it is desirable to select the method of controlling it based on the etching amount deviation distribution. Meanwhile, when it is required to control the thickness of the first wafer W precisely according to the shape of the rear surface Wb, it is desirable to control it based on the etching amount.

The above exemplary embodiment has been described for the example where various processings are performed on the rear surface Wb of the first wafer W, that is, on one side of the wafer. However, the technique of the present disclosure is also applicable to a case where various processings are performed on both sides of the wafer. Hereinafter, a case where a cut surface of a disk-shaped silicon wafer (hereinafter simply referred to as "wafer") obtained by being cut out from a single crystalline silicon ingot with a wire saw or the like is flattened and smoothed to equalize the thickness of the wafer will be described.

In this exemplary embodiment, a wafer W as a substrate cut out from an ingot with a wire saw or the like and lapped is subjected to a processing of improving in-surface thickness uniformity by using a wafer processing system 200 shown in **FIG. 14**. Hereinafter, cut surfaces of the wafer W are referred to as a first surface Wa and a second surface Wb. The first surface Wa is a surface opposite to the second surface Wb. Further, the first surface Wa and the second surface Wb may sometimes be collectively referred to as a surface of the wafer W.

The wafer processing system 200 further includes inverting apparatuses 210 and 212 in addition to the components of the wafer processing system 1 of the above-described exemplary embodiment, and has a processing apparatus 220 instead of the processing apparatus 80. The other configurations of the wafer processing system 200 are the same as those of the wafer processing system 1, so detailed description thereof will be omitted here.

The etching apparatus 40 is configured to etch the silicon (Si) of the first surface Wa after being ground or the second surface Wb after being ground in the processing apparatus 220. In order to improve a throughput of a wafer processing, a plurality of etching apparatuses 40 may be provided. The cleaning apparatus 60 is configured to clean at least the first surface Wa or the second surface Wb after being ground in the processing apparatus 220.

The inverting apparatus 210 is stacked on the etching apparatus 40 and the thickness measuring apparatus 41. The inverting apparatus 211 is stacked on the cleaning apparatus 60, the thickness measuring apparatus 61, and the buffer apparatus 62. These inverting apparatuses 210 and 211 are configured to invert the first surface Wa and the second surface Wb of the wafer W upside down. Configurations of the inverting apparatuses 210 and 211 are not particularly limited.

The processing apparatus 220 has a rotary table 221. The rotary table 221 is configured to be rotatable about a vertical rotation center line 222 by a rotating mechanism (not shown). Provided on the rotary table 221 are four chucks 223 each configured to attract and hold the wafer W. Among the four chucks 223, two first chucks 223a are ones for use in grinding at a first processing position C1. These two first chucks 223a are arranged at point-symmetrical positions with the rotation center line 222 therebetween. The remaining two second chucks 223b are ones for use in grinding at a second processing position C2. These two second chucks 223b are also arranged at point-symmetrical positions with the rotation center line 222 therebetween. That is, the first chucks 223a and the second chucks 223b are alternately arranged in a circumferential direction.

The four chucks 223 are configured to be movable to delivery positions B1 and B2 and the processing positions C1 and C2 as the rotary table 221 is rotated. Further, each of the four chucks 223 is configured to be rotatable around a vertical axis by a rotating mechanism (not shown).

The first delivery position B1 is a position on the negative X-axis and positive Y-axis side of the rotary table 221, and a delivery of the wafer W onto the first chuck 223a is performed at this first delivery position B1 when grinding the first surface Wa. The second delivery position B2 is a position on the negative X-axis and negative Y-axis side of the rotary table 221, and a delivery of the wafer W onto the second chuck 223b is performed at this second delivery position B2 when grinding the second surface Wb.

The first processing position C1 is a position on the positive X-axis and negative Y-axis side of the rotary table 221, and a first grinding device 230 is disposed at this first processing position C1. The first grinding device 230 has a grinder 231 provided with a grinding whetstone (not shown) configured to be rotatable in an annular shape. Further, the grinder 231 is configured to be movable in a vertical direction along a supporting column 232. As an example, the first grinding device 230 grinds the first surface Wa or the second surface Wb of the wafer W held by the first chuck 223a.

The second processing position C2 is a position on the positive X-axis and positive Y-axis side of the rotary table 221, and a second grinding device 240 is disposed at this second processing position C2. The second grinding device 240 has a grinder 241 provided with a grinding whetstone (not shown) configured to be rotatable in an annular shape. Further, the grinder 241 is configured to be movable in a vertical direction along a supporting column 242. As an example, the second grinding device 240 grinds the second surface Wb or the first surface Wa of the wafer W held by the second chuck 223b.

**Additionally,** a thickness measuring apparatus (not shown) configured to measure the thickness of the wafer W after being ground may be provided at the delivery positions B1 and B2 or the processing positions C1 and C2.

Now, wafer processings (both sides processing) performed by using the wafer processing system 200 configured as described above will be described. Below, three patterns of the wafer processing will be explained.

In the wafer processing of the first pattern, the cassette C accommodating a plurality of wafers W therein is first placed on the cassette placing table 10 of the carry-in/out station 2. In the cassette C, each wafer W is stored with the first surface Wa facing upwards and the second surface Wb facing downwards. Next, the wafer W in the cassette C is taken out by the wafer transfer device 20 and transferred to the transition device 30. The wafer W transferred to the transition device 30 is then transferred to the buffer apparatus 62 by the wafer transfer device 50. In the buffer apparatus 62, the center position of the wafer W with respect to the chuck 83 and/or the direction of the wafer W in the horizontal direction may be adjusted.

Subsequently, the wafer W is transferred to the processing apparatus 220 by the wafer transfer device 70, and delivered to the first chuck 223a at the first delivery position B1. The second surface Wb of the wafer W is attracted to and held by the first chuck 223a.

Next, the rotary table 221 is rotated to move the wafer W to the first processing position C1. Then, the first surface Wa of the wafer W is ground by the first grinding device 230 (process S101 in **FIG. 15**). In the process S101, the control device 90 may control the processing apparatus 220 to grind the first surface Wa in a V-shape to form a recessed portion War in the first surface Wa after being ground such that a central portion of the first surface Wa is recessed as compared to a peripheral portion thereof, as shown in **FIG. 16A.**

Thereafter, the rotary table 221 is rotated to move the wafer W to the first delivery position B1. At the first delivery position B1, the first surface Wa of the wafer W after being ground may be cleaned by a cleaning device (not shown).

Then, the wafer W is transferred to the cleaning apparatus 60 by the wafer transfer device 70. In the cleaning apparatus 60, the first surface Wa and the second surface Wb of the wafer W may be cleaned (process S102 in **FIG. 15**).

Subsequently, the wafer W is transferred to the inverting apparatus 211 by the wafer transfer device 70. In the inverting apparatus 211, the first surface Wa and the second surface Wb of the wafer W are inverted upside down (process S103 in **FIG. 15**). That is, the wafer W is inverted such that the first surface Wa faces downwards and the second surface Wb faces upwards.

Next, the wafer W is transferred to the processing apparatus 220 by the wafer transfer device 70, and delivered onto the second chuck 223b at the second delivery position B2. The first surface Wa of the wafer W is attracted to and held by the second chuck 223b.

Thereafter, the rotary table 221 is rotated to move the wafer W to the second processing position C2. Then, the second surface Wb of the wafer W is ground by the second grinding device 240 (process S104 in **FIG. 15**). In the process S104, the control device 90 may control the processing apparatus 220 to grind the second surface Wb in a V-shape to form a recessed portion Wbr such that a central portion of the second surface Wb is recessed as compared to a peripheral portion thereof, as shown in **FIG. 16B.**

Subsequently, the rotary table 221 is rotated to move the wafer W to the second delivery position B2. At the second delivery position B2, the second surface Wb of the wafer W after being ground may be cleaned by a cleaning device (not shown).

Next, the wafer W is transferred to the cleaning apparatus 60 by the wafer transfer device 70. In the cleaning apparatus 60, the second surface Wb and the first surface Wa of the wafer W are cleaned (process S105 in **FIG. 15**).

Thereafter, the wafer W is transferred to the thickness measuring apparatus 61 by the wafer transfer device 70 or the wafer transfer device 50. In the thickness measuring apparatus 61, the thickness of the wafer W after being subjected to the grinding of both the first surface Wa and the second surface Wb is measured at multiple points to obtain a thickness distribution of the wafer W after being ground, and, also, flatness of the wafer W is calculated (process S106 in **FIG. 15**). The thickness distribution and the flatness of the wafer W thus calculated are outputted to, for example, the control device 90. Further, when the processing apparatus 220 is provided with a thickness measuring device, the thickness of the wafer W after being ground may be measured by the thickness measuring device of the processing apparatus 220.

The control device 90 determines an optimal etching condition for the second surface Wb from the received thickness distribution and flatness of the wafer W so as to optimize an etching amount deviation distribution in an etching processing of the second surface Wb (process S107 in **FIG. 15**). This process S107 is the same as the process S3 in the above-described exemplary embodiment.

Next, the wafer W is transferred to the etching apparatus 40 by the wafer transfer device 50. In the etching apparatus 40, the second surface Wb of the wafer W is etched by the etching liquid E under the optimal etching condition determined in the process S107 (process S108 in **FIG. 15**). In the process S108, the etching amount deviation distribution is optimized by etching the second surface Wb under the optimal etching condition, so that the second surface Wb is made into a target shape, that is, made flat in the present exemplary embodiment, as shown in **FIG. 16C.**

Next, the wafer W is transferred to the inverting apparatus 210 by the wafer transfer device 50. In the inverting apparatus 210, the first surface Wa and the second surface Wb of the wafer W are inverted upside down (process S109 in **FIG. 15**). That is, the wafer W is inverted such that the first surface Wa faces upwards and the second surface Wb faces downward.

Then, the wafer W is transferred to the thickness measuring apparatus 41 by the wafer transfer device 50. In the thickness measuring apparatus 41, the thickness of the wafer W is measured at multiple points to obtain a thickness distribution of the wafer W after being ground, and, also, flatness of the wafer W is calculated (process S110 in **FIG. 15**). The thickness distribution and the flatness of the wafer W thus calculated are outputted to, for example, the control device 90.

The control device 90 determines optimal etching condition for the first surface Wa from the received thickness distribution and flatness of the wafer W so as to optimize an etching amount distribution in an etching processing of the first surface Wa (process S111 in **FIG. 15**). This process S111 is the same as the process S3 in the above-described exemplary embodiment.

Next, the wafer W is transferred to the etching apparatus 40 by the wafer transfer device 50. In the etching apparatus 40, the first surface Wa of the wafer W is etched by the etching liquid E under the optimal etching condition determined in the process S111 (process S112 in **FIG. 15**). In the process S112, the etching amount distribution is optimized by etching the first surface Wa under the optimal etching condition, so that the first surface Wa is made into a target shape, that is, made flat in the present exemplary embodiment, as illustrated in **FIG. 16D.**

Thereafter, the wafer W is transferred to the thickness measuring apparatus 41 by the wafer transfer device 50. In the thickness measuring device 41, the thickness of the wafer W after being subjected to the etching of both the first surface Wa and the second surface Wb is measured at multiple points to obtain a thickness distribution of the wafer W after being ground (process S113 in **FIG. 15**). Additionally, flatness of the wafer W may be calculated. This process S111 is the same as the process S6 in the above-described exemplary embodiment.

Afterwards, the wafer W after being subjected to all the required processes is transferred to the cassette C of the cassette placing table 10 via the transition device 30. In this way, the series of processes of the wafer processing in the wafer processing system 200 are completed. Further, the wafer W processed in the wafer processing system 200 may be further subjected to polishing at the outside of the wafer processing system 200.

According to the present exemplary embodiment, the same effect as in the above-described exemplary embodiment can be obtained. That is, the etching amount deviation distribution of the second surface Wb in the process S108 is optimized, and the etching amount distribution of the first surface Wa in the process S112 is optimized. As a result, the surface shape of the wafer W after being etched can be appropriately controlled, and the thickness of the wafer W can be appropriately controlled.

In the etching in the process S108 (S112), due to the characteristics of the process, the etching amount deviation distribution (etching amount distribution) tends to have a V-shape that is recessed downwards as the etching amount deviation (etching amount) near the center of the wafer W becomes small. In other words, the surface of the wafer after being etched tends to have an A-shape that is projected upwards. In this regard, it is desirable that the surface of the wafer after being ground is V-shaped.

In this way, by grinding the first surface Wa and the second surface Wb into a shape that is easy to control by the etching, the precision of the optimization of the etching amount deviation distributions of the first surface Wa and the second surface Wb in the processes S108 and S110 can be improved.

Furthermore, in the present exemplary embodiment, the determination of the optimal etching condition in the processes S107 and S111 is performed based on the thickness distribution and the flatness of the wafer W obtained in the processes S106 and S110, respectively. In this regard, the optimal etching condition for the second surface Wb and the first surface Wa may be determined in the processes S107 and Sill based on the thickness distribution and the flatness of the wafer W acquired in the process S106.

The wafer processing of the second pattern is different from the wafer processing of the first pattern in the processes S107 and S108. Further, a state change of the wafer W processed in the second pattern is the same as that processed in the first pattern shown in **FIG. 16A** to **FIG. 16D.**

First, by performing processes S201 to S206 as shown in **FIG. 17**, grinding of both sides of the wafer W, cleaning of both sides of the wafer W, and measuring of the thickness of the wafer W are performed sequentially. These processes S201 to S206 are the same as the processes S101 to S106 of the first pattern.

Subsequently, in a process S207, an optimal etching condition for the second surface Wb is determined based on the thickness distribution and the flatness of the wafer W acquired in the process S206 so as to optimize an etching amount distribution in an etching processing of the second surface Wb. That is, although the etching amount deviation distribution is optimized in the process S107 of the above-described exemplary embodiment, the etching amount distribution is optimized in the process S207.

Afterwards, in a process S208, the second surface Wb of the wafer W is etched by the etching liquid E under the optimal etching condition determined in the process S207. At this time, by etching the second surface Wb under the optimal etching condition, the etching amount distribution is optimized.

Next, by performing processes S209 to S213, etching of the first surface Wa and measuring of the thickness of the wafer W are performed in sequence. These processes S209 to S213 are the same as the processes S109 to S113 of the first pattern. In the process S211, an optimal etching condition capable of optimizing an etching amount distribution of the first surface Wa is determined, the same as in the process Sill of the first pattern.

In the present exemplary embodiment as well, the same effect as in the above-described exemplary embodiment can be obtained. That is, the etching amount distribution of the second surface Wb in the process S208 is optimized, and the etching amount distribution of the first surface Wa in the process S212 is optimized. As a result, the surface shape of the wafer W after being etched can be appropriately controlled, and the thickness of the wafer W can be appropriately controlled.

The wafer processing of the third pattern is different from the wafer processing of the first (second) pattern after the process S106 (S206).

First, by performing processes S301 to S305 as illustrated in **FIG. 18**, grinding of both sides of the wafer W and cleaning of both sides of the wafer W are performed in sequence. These processes S301 to S306 are the same as the processes S101 to S105 of the first pattern. In the process S301, the first surface Wa is ground, as shown in **FIG. 19A**. As an example, the first surface Wa is ground into a V-shape so as to form a recessed portion War so that a central portion of the first surface Wa is recessed as compared to a peripheral portion thereof. In the process S304, the second surface Wb is ground, as illustrated in **FIG. 19B**. As an example, the second surface Wb is ground into a V-shape so as to form a recessed portion Wbr so that a central portion of the second surface Wb is recessed as compared to a peripheral portion thereof.

Thereafter, in a process S306, the second surface Wb is etched, as shown in **FIG. 19C**. At this time, an etching amount deviation (or etching amount) of the second surface Wb is uniform within the surface thereof, that is, an etching amount deviation distribution (or etching amount distribution) is uniform. That is, the third pattern is different from the first pattern and the second pattern in this point, and the etching amount deviation distribution or the etching amount distribution is not optimized in the third pattern.

Subsequently, by performing processes S307 to S311, measuring of the thickness of the wafer W and etching of the first surface Wa are performed in sequence. These processes S307 to S311 are the same as the processes S109 to S113 of the first pattern. In the process S309, an optimal etching condition capable of optimizing an etching amount distribution of the first surface Wa is determined, the same as in the process Sill of the first pattern. Then, in the process S310, the first surface Wa is etched under the optimal etching condition determined in the process S309, as illustrated in **FIG. 19D.** That is, after the etching in the present exemplary embodiment, the thickness distribution of the wafer W becomes uniform.

Additionally, in the present exemplary embodiment, when performing the processes S301 to S311 continually for a plurality of wafers W, the etching amount deviation (or etching amount) of the second surface Wb in the process S306 is uniform within the surface. In other words, the second surface Wb is etched under the same etching conditions for the plurality of wafers W.

In the present exemplary embodiment as well, the same effect as in the above-described exemplary embodiment can be obtained. That is, even when the etching amount deviation of the second surface Wb in the process S306 is uniform within the surface of the wafer, the etching amount distribution of the first surface Wa in the process S310 is optimized. As a result, the surface shape of the wafer W after being etched can be appropriately controlled, and the thickness of the wafer W can be appropriately controlled.

It should be noted that the above-described exemplary embodiment is illustrative in all aspects and is not anyway limiting. The above-described exemplary embodiment may be omitted, replaced and modified in various ways without departing from the scope and the spirit of claims.

## EXPLANATION OF CODES

1: Wafer processing system
40: Etching apparatus
90: Control device
E: Etching liquid
T: Combined wafer
W: First wafer
S: Second wafer

## Claims

**1.** A substrate processing method of processing a substrate, the substrate processing method comprising:

determining an optimal etching condition; and
etching a surface of an etching target of the substrate by supplying an etching liquid to the surface based on the optimal etching condition,
wherein the determining of the optimal etching condition comprises:

acquiring etching index distributions in a radial direction of the etching target when the surface of the etching target is etched under multiple different etching conditions;
optimizing, by using an optimization method, a combination of the etching index distributions used in superimposition and a superimposing number of the etching index distributions by superimposing the etching index distributions respectively corresponding to the multiple etching conditions such that a shape of the surface of the etching target becomes a target shape; and
determining the optimal etching condition by integrating the etching conditions corresponding to the optimized combination.

**2.** The substrate processing method of Claim 1,

wherein the substrate includes multiple substrates,
in the determining of the optimal etching condition, etching of the surface of the etching target under the multiple different etching conditions is performed for each substrate, and
a processing time of the etching on the etching target of each substrate is a same.

**3.** The substrate processing method of Claim 1 or 2,
wherein in the optimization method, etching precision of the surface of the etching target and a supply time of the etching liquid to the surface of the etching target are optimized at a same time.

**4.** The substrate processing method of Claim 3,
wherein the etching precision is calculated as a weighted linear sum of flatness of the etching target and non-uniformity of a thickness distribution of the etching target.

**5.** The substrate processing method of Claim 1 or 2,

wherein when etching the surface of the etching target, the etching liquid is supplied from an etching liquid supply while rotating the substrate and moving the etching liquid supply in the radial direction through a center of the etching target, and

when a reciprocating movement of the etching liquid supply between both ends of the etching target is defined as a 1 (one) loop, the superimposing number of the etching index distributions is optimized in a unit of 0.5 loop in the optimization method.

**6.** The substrate processing method of Claim 1 or 2, further comprising:

obtaining, before the etching of the surface of the etching target, a thickness distribution of the etching target by measuring a thickness of the etching target,

wherein the optimal etching condition is determined based on the obtained thickness distribution of the etching target.

**7.** The substrate processing method of Claim 6, further comprising:
thinning, before the measuring of the thickness of the etching target, the substrate.

**8.** The substrate processing method of Claim 1 or 2,
wherein the etching index distribution is at least one of an etching amount deviation distribution obtained by subtracting, from etching amounts within the surface of the substrate, an average of the etching amounts, or an etching amount distribution of the etching amounts within the surface of the substrate.

**9.** The substrate processing method of Claim 8, further comprising:

grinding a first surface and a second surface of the substrate;

obtaining a thickness distribution of the substrate by measuring a thickness of the substrate;

etching the second surface based on the optimal etching condition that optimizes the etching amount deviation distribution from the thickness distribution; and

etching the first surface based on the optimal etching condition that optimizes the etching amount distribution from the thickness distribution.

**10.** The substrate processing method of Claim 8, further comprising:

grinding a first surface and a second surface of the substrate;

obtaining a thickness distribution of the substrate by measuring a thickness of the substrate;

etching the second surface based on the optimal etching condition that optimizes the etching amount distribution from the thickness distribution; and

etching the first surface based on the optimal etching condition that optimizes the etching amount distribution from the thickness distribution.

**11.** The substrate processing method of Claim 8, further comprising:

grinding a first surface and a second surface of the substrate;

obtaining a thickness distribution of the substrate by measuring a thickness of the substrate;

etching the second surface based on a preset etching amount deviation distribution or etching amount distribution; and

etching the first surface based on the optimal etching condition that optimizes the etching amount distribution from the thickness distribution.

**12.** A substrate processing system configured to process a substrate, the substrate processing system comprising:

an etching apparatus configured to etch a surface of an etching target of the substrate by supplying an etching liquid to the surface; and

a control device configured to control the etching of the etching target in the etching apparatus based on an optimal etching condition,

wherein the control device performs:

acquiring etching index distributions in a radial direction of the etching target when the surface of the etching target is etched under multiple different etching conditions;
optimizing, by using an optimization method, a combination of the etching index distributions used in superimposition and a superimposing number of the etching index distributions by superimposing the etching index distributions respectively corresponding to the multiple etching conditions such that a shape of the surface of the etching target becomes a target shape; and
determining the optimal etching condition by integrating the etching conditions corresponding to the optimized combination.

**13.** The substrate processing system of Claim 12,

wherein the substrate includes multiple substrates,
when determining the optimal etching condition, the control device performs the etching of the surface of the etching target under the multiple different etching conditions for each substrate, and controls a processing time of the etching on the etching target of each substrate to be same.

**14.** The substrate processing system of Claim 12 or 13,
wherein in the optimization method, the control device optimizes etching precision of the surface of the etching target and a supply time of the etching liquid to the surface of the etching target at a same time.

**15.** The substrate processing system of Claim 14,
wherein the control device calculates, as the etching precision, a weighted linear sum of flatness of the etching target and non-uniformity of a thickness distribution of the etching target.

**16.** The substrate processing system of Claim 12 or 13,
wherein the etching apparatus comprises:

a substrate holder configured to hold the substrate;
a rotating mechanism configured to rotate the substrate holder;
an etching liquid supply configured to supply the etching liquid from above the surface of the etching target of the substrate held by the substrate holder; and
a moving mechanism configured to move the etching liquid supply in a horizontal direction, and
wherein when a reciprocating movement of the etching liquid supply between both ends of the etching target is defined as 1 (one) loop, the control device optimizes the superimposing number of the etching index distributions in a unit of 0.5 loop in the optimization method.

**17.** The substrate processing system of Claim 12 or 13, further comprising:

a thickness measuring device configured to measure a thickness of the etching target before being etched,
wherein the control device determines the optimal etching condition based on a thickness distribution of the etching target acquired from the thickness of the etching target measured by the thickness measuring device.

**18.** The substrate processing system of Claim 17, further comprising:

a thinning device configured to thin the substrate,
wherein the thickness measuring device measures the thickness of the etching target in the substrate after being thinned.

**19.** The substrate processing system of Claim 12 or 13,
wherein the etching index distribution is at least one of an etching amount deviation distribution obtained by subtracting, from etching amounts within the surface of the substrate, an average of the etching amounts, or an etching amount distribution of the etching amounts within the surface of the substrate.

*FIG. 1*

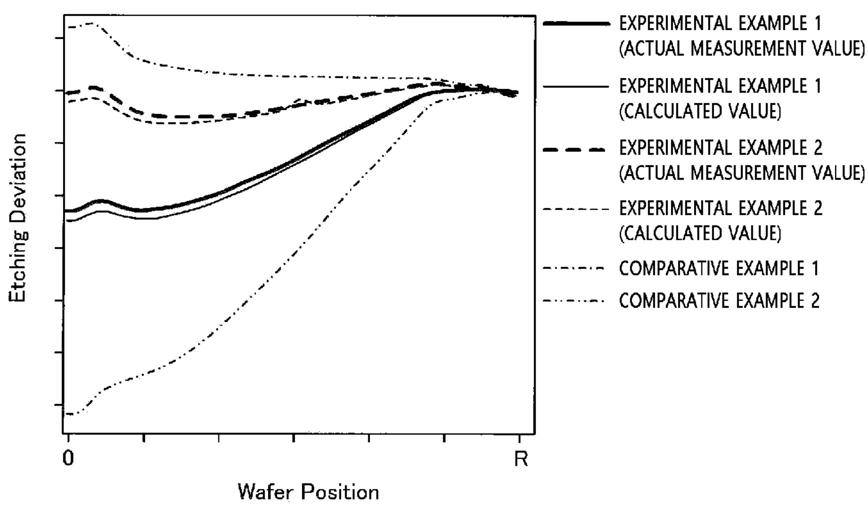
Etching Deviation
0
R
Wafer Position
EXPERIMENTAL EXAMPLE 1 (ACTUAL MEASUREMENT VALUE)
EXPERIMENTAL EXAMPLE 1 (CALCULATED VALUE)
EXPERIMENTAL EXAMPLE 2 (ACTUAL MEASUREMENT VALUE)
EXPERIMENTAL EXAMPLE 2 (CALCULATED VALUE)
COMPARATIVE EXAMPLE 1
COMPARATIVE EXAMPLE 2

*FIG. 2*

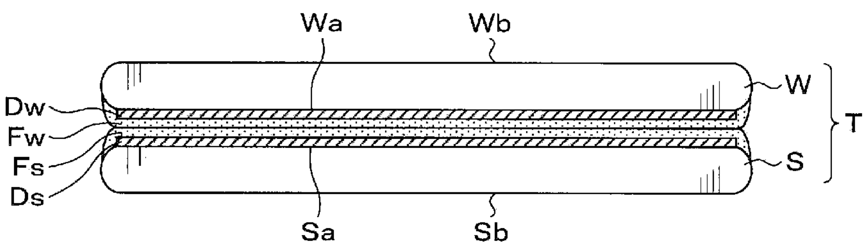
Wa
Wb
W
T
S
Dw
Fw
Fs
Ds
Sa
Sb

FIG. 3

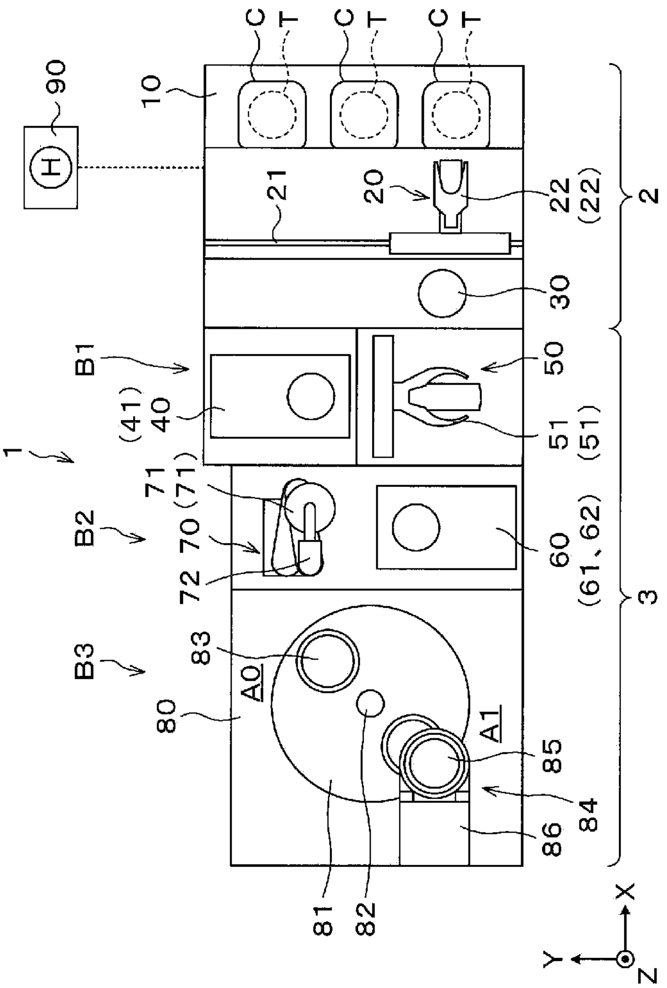
1
90
H
10
C
T
20
21
22
(22)
2
30
B1
B2
B3
40
(41)
50
51
(51)
60
(61, 62)
70
71
(71)
72
3
80
81
82
83
84
85
86
A0
A1
X
Y
Z

FIG. 4

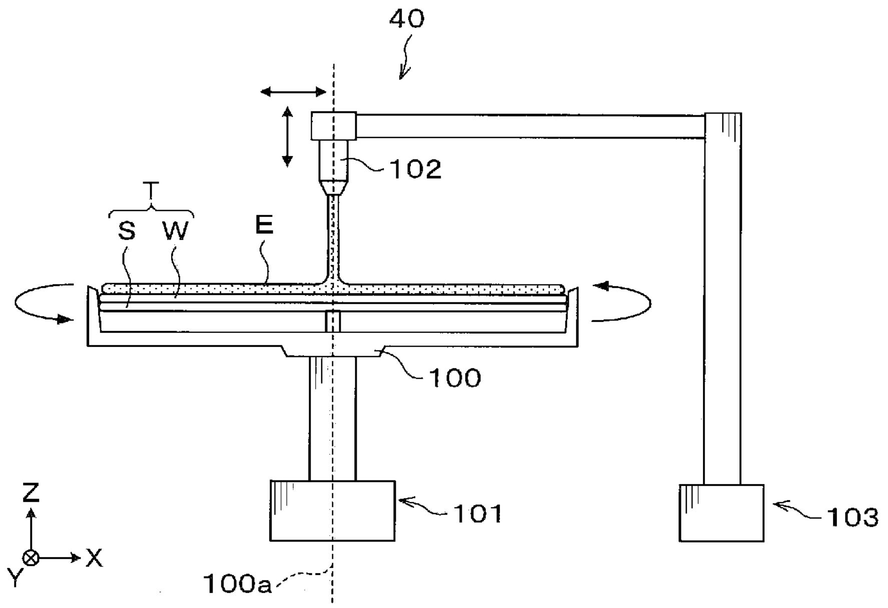


FIG. 5

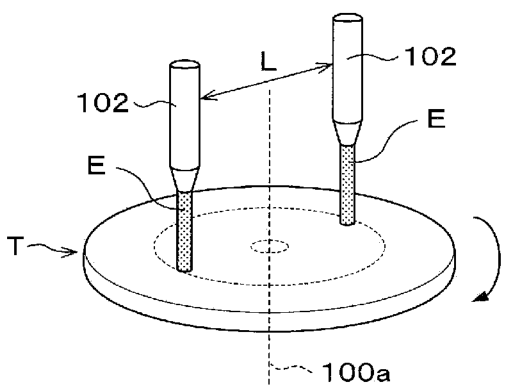

FIG. 6

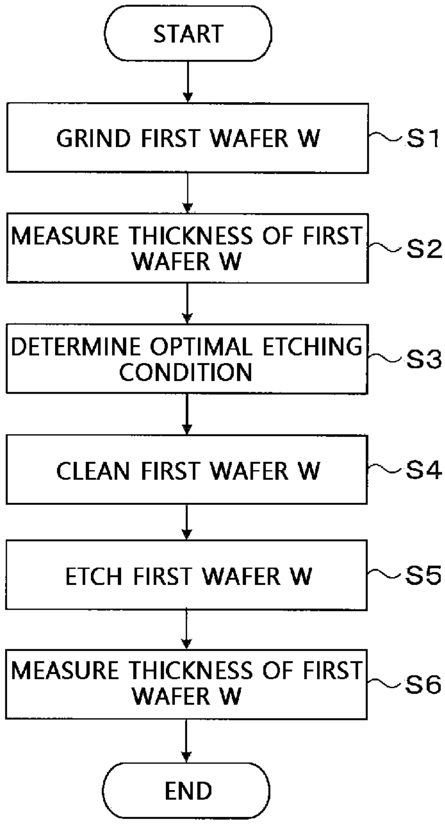
START
GRIND FIRST WAFER W
S1
MEASURE THICKNESS OF FIRST WAFER W
S2
DETERMINE OPTIMAL ETCHING CONDITION
S3
CLEAN FIRST WAFER W
S4
ETCH FIRST WAFER W
S5
MEASURE THICKNESS OF FIRST WAFER W
S6
END

FIG. 7

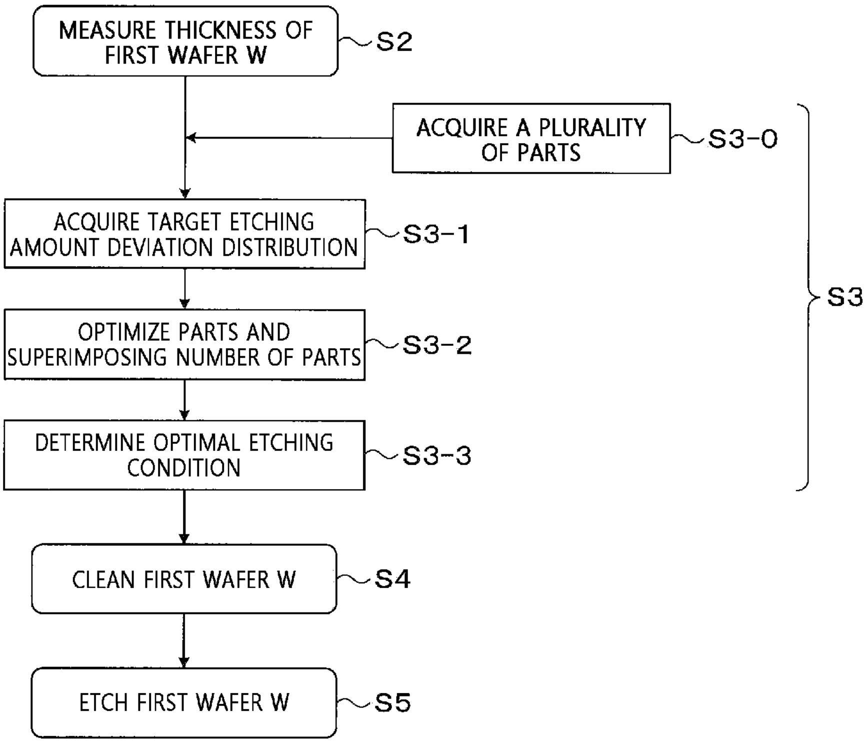
MEASURE THICKNESS OF FIRST WAFER W
S2
ACQUIRE A PLURALITY OF PARTS
S3-0
ACQUIRE TARGET ETCHING AMOUNT DEVIATION DISTRIBUTION
S3-1
OPTIMIZE PARTS AND SUPERIMPOSING NUMBER OF PARTS
S3-2
DETERMINE OPTIMAL ETCHING CONDITION
S3-3
S3
CLEAN FIRST WAFER W
S4
ETCH FIRST WAFER W
S5

FIG. 8

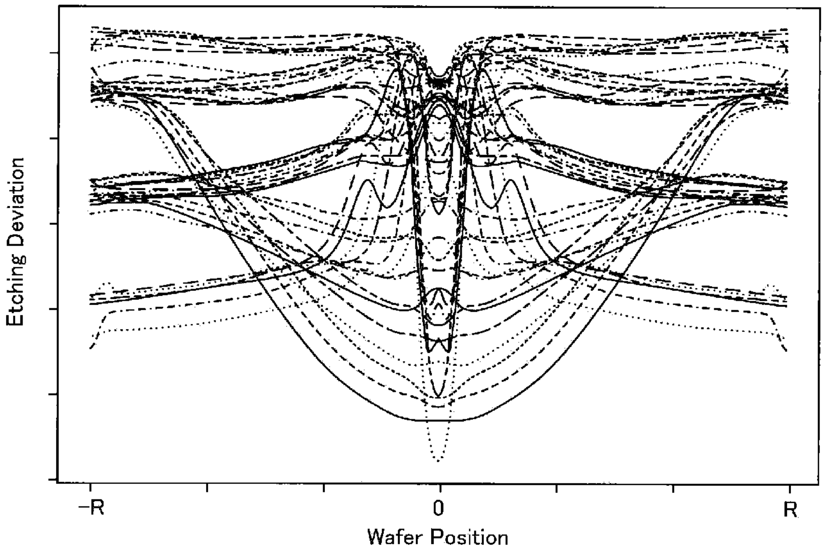
Etching Deviation
-R
0
R
Wafer Position

FIG. 9

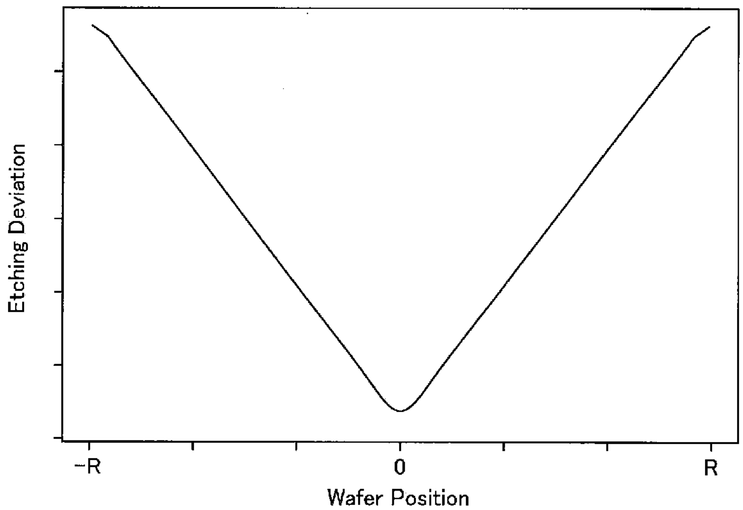
Etching Deviation
-R
0
R
Wafer Position

FIG. 10

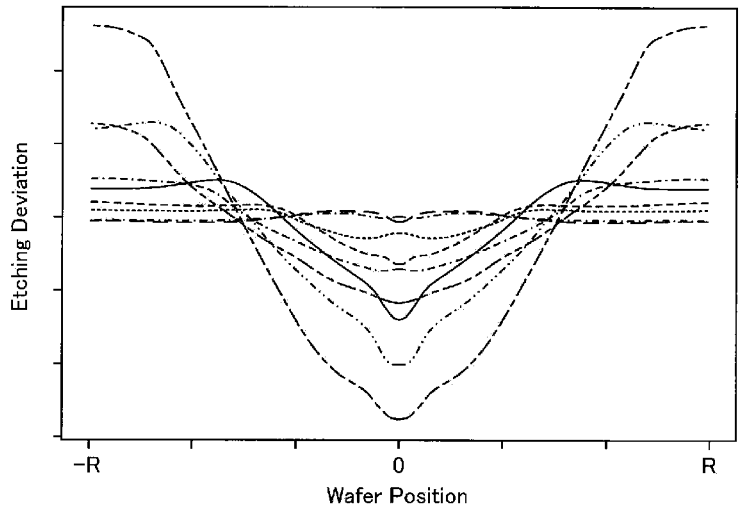
Etching Deviation
-R
0
R
Wafer Position

FIG. 11

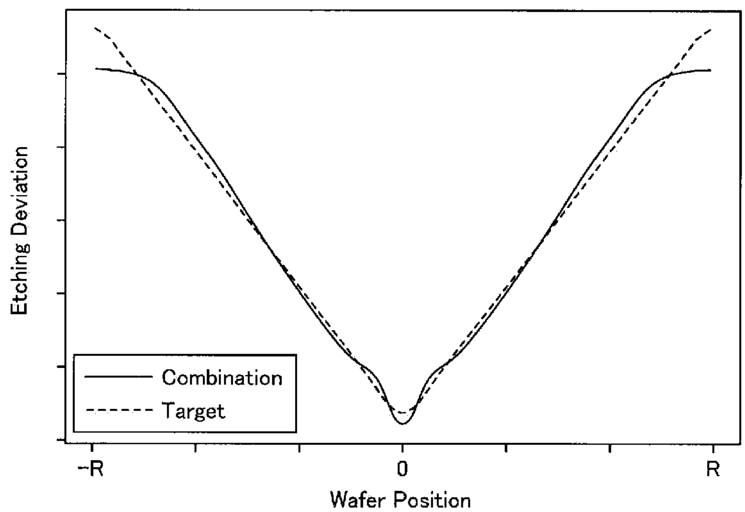
Etching Deviation
Combination
Target
-R
0
R
Wafer Position

FIG. 12

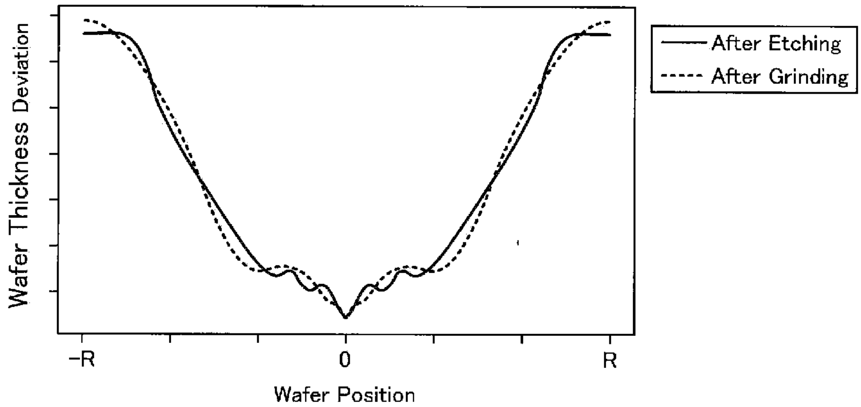
Wafer Thickness Deviation
After Etching
After Grinding
-R
0
R
Wafer Position

FIG. 13

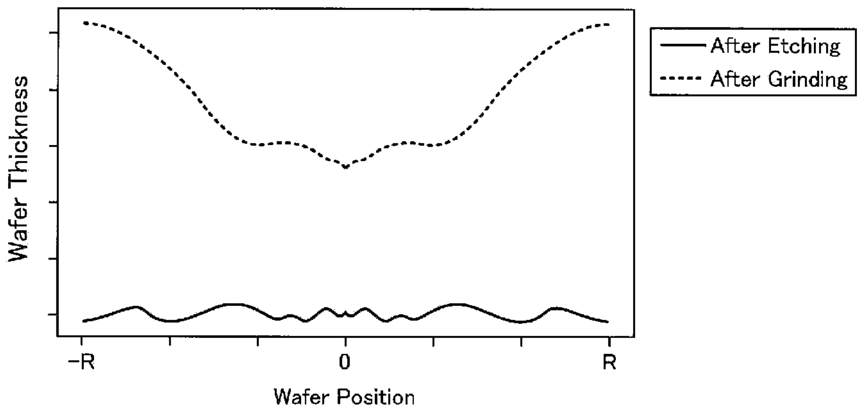
Wafer Thickness
After Etching
After Grinding
-R
0
R
Wafer Position

FIG. 14

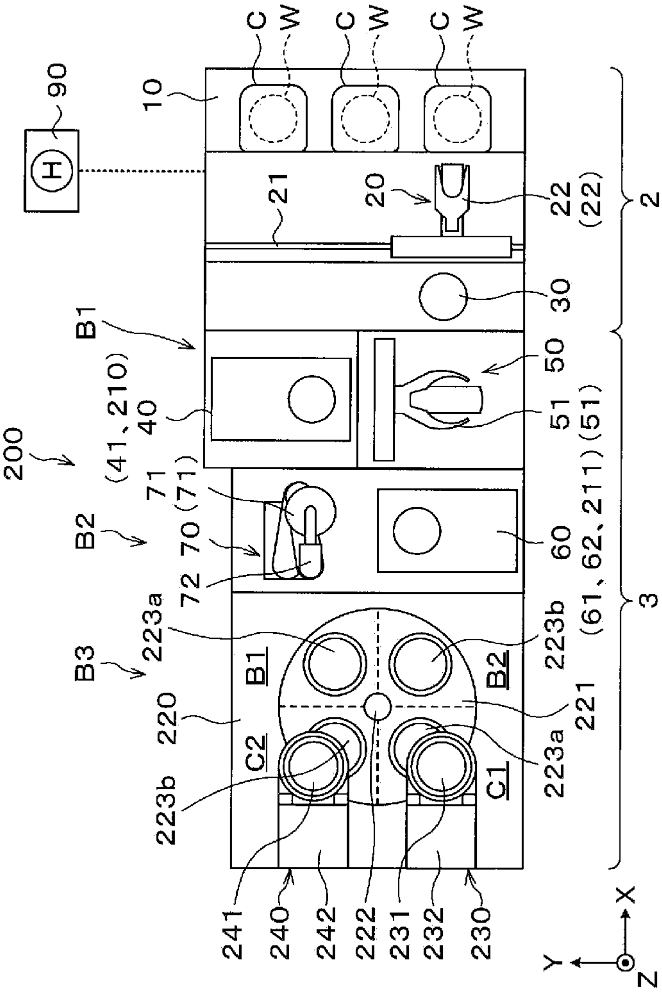

200
B1
B2
B3
(41, 210)
40
71
(71)
72
70
223a
220
B1
C2
223b
241
240
242
222
231
232
230
C1
223a
221
B2
223b
60
(61, 62, 211)
(51)
51
50
30
22
(22)
20
21
H
90
10
C
W
2
3
X
Y
Z

*FIG. 15*

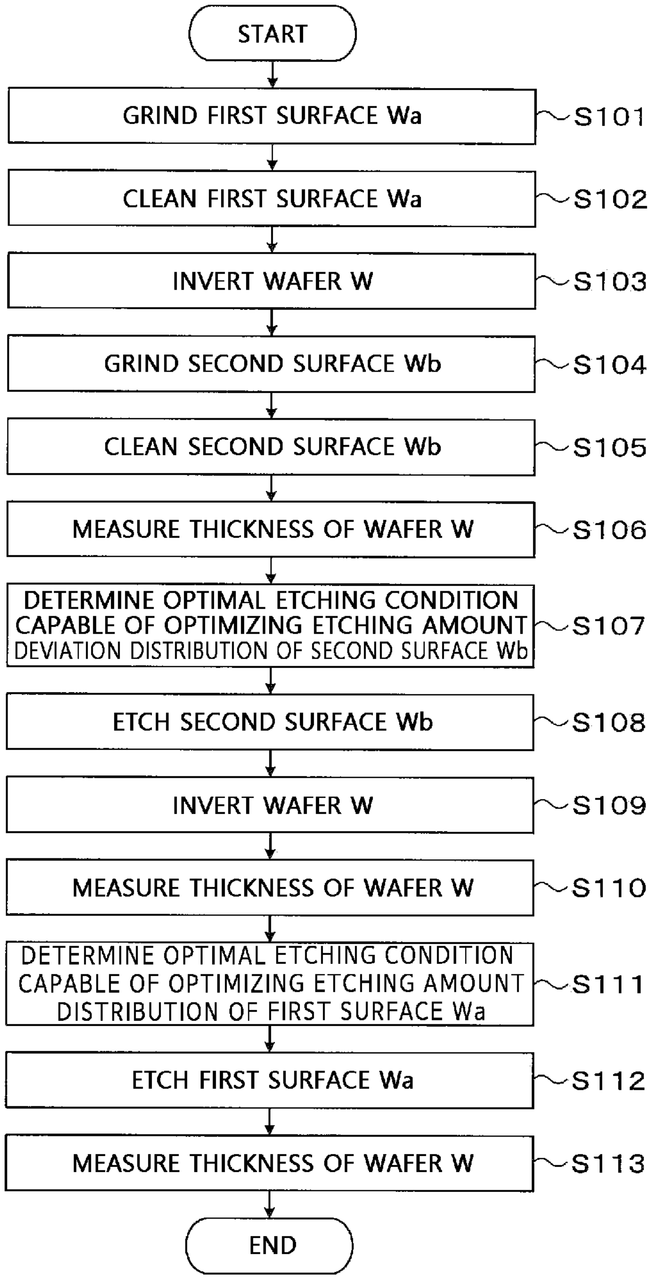
START
GRIND FIRST SURFACE Wa
S101
CLEAN FIRST SURFACE Wa
S102
INVERT WAFER W
S103
GRIND SECOND SURFACE Wb
S104
CLEAN SECOND SURFACE Wb
S105
MEASURE THICKNESS OF WAFER W
S106
DETERMINE OPTIMAL ETCHING CONDITION CAPABLE OF OPTIMIZING ETCHING AMOUNT DEVIATION DISTRIBUTION OF SECOND SURFACE Wb
S107
ETCH SECOND SURFACE Wb
S108
INVERT WAFER W
S109
MEASURE THICKNESS OF WAFER W
S110
DETERMINE OPTIMAL ETCHING CONDITION CAPABLE OF OPTIMIZING ETCHING AMOUNT DISTRIBUTION OF FIRST SURFACE Wa
S111
ETCH FIRST SURFACE Wa
S112
MEASURE THICKNESS OF WAFER W
S113
END

FIG. 16A

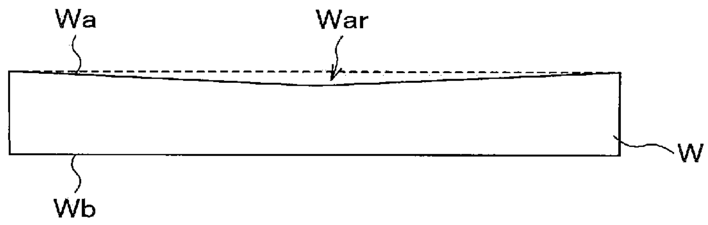


FIG. 16B

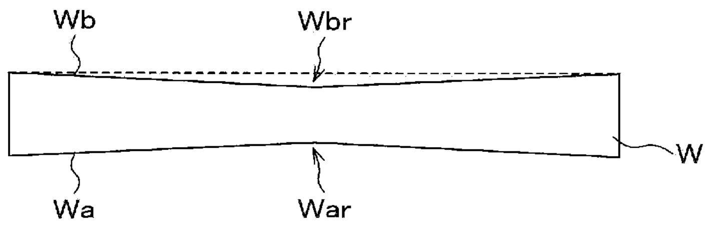


FIG. 16C

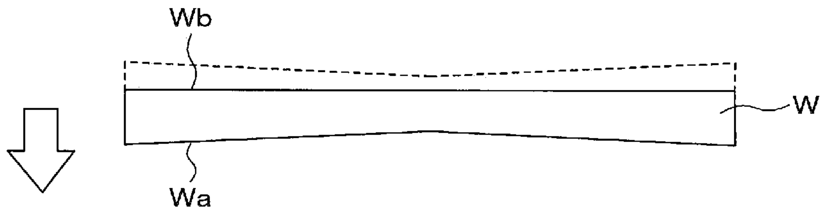


FIG. 16D

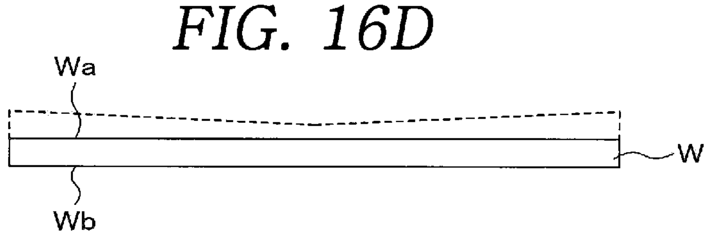

FIG. 17

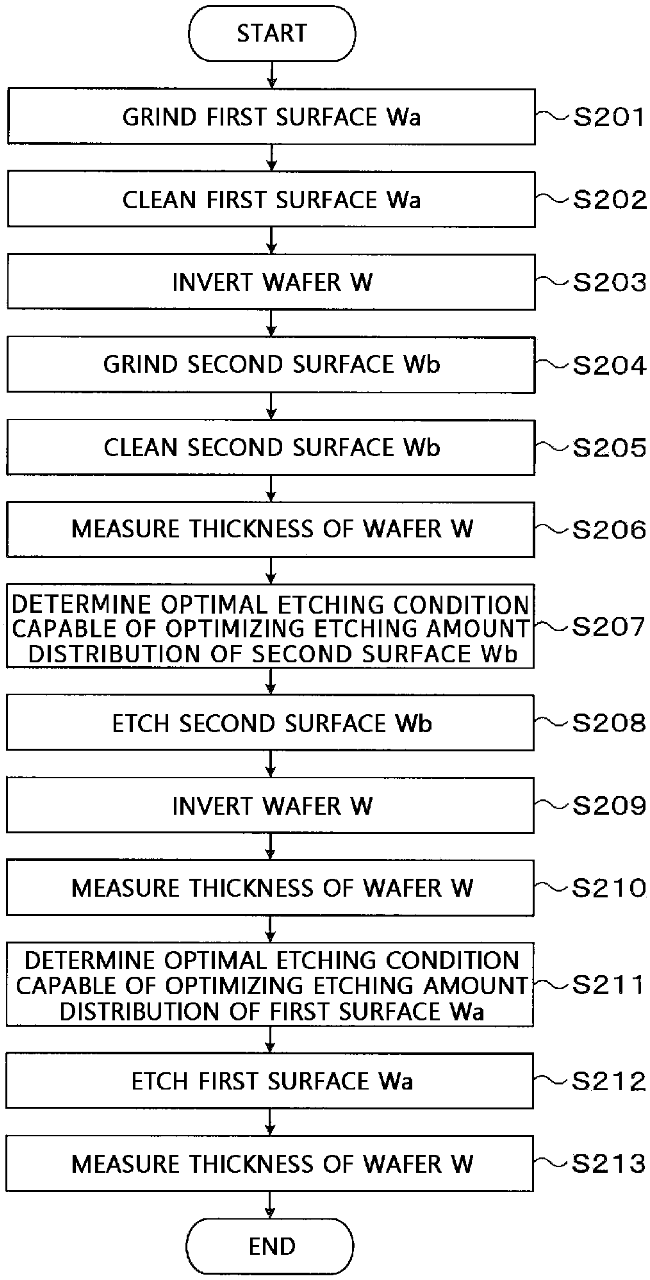
START
GRIND FIRST SURFACE Wa
S201
CLEAN FIRST SURFACE Wa
S202
INVERT WAFER W
S203
GRIND SECOND SURFACE Wb
S204
CLEAN SECOND SURFACE Wb
S205
MEASURE THICKNESS OF WAFER W
S206
DETERMINE OPTIMAL ETCHING CONDITION CAPABLE OF OPTIMIZING ETCHING AMOUNT DISTRIBUTION OF SECOND SURFACE Wb
S207
ETCH SECOND SURFACE Wb
S208
INVERT WAFER W
S209
MEASURE THICKNESS OF WAFER W
S210
DETERMINE OPTIMAL ETCHING CONDITION CAPABLE OF OPTIMIZING ETCHING AMOUNT DISTRIBUTION OF FIRST SURFACE Wa
S211
ETCH FIRST SURFACE Wa
S212
MEASURE THICKNESS OF WAFER W
S213
END

FIG. 18

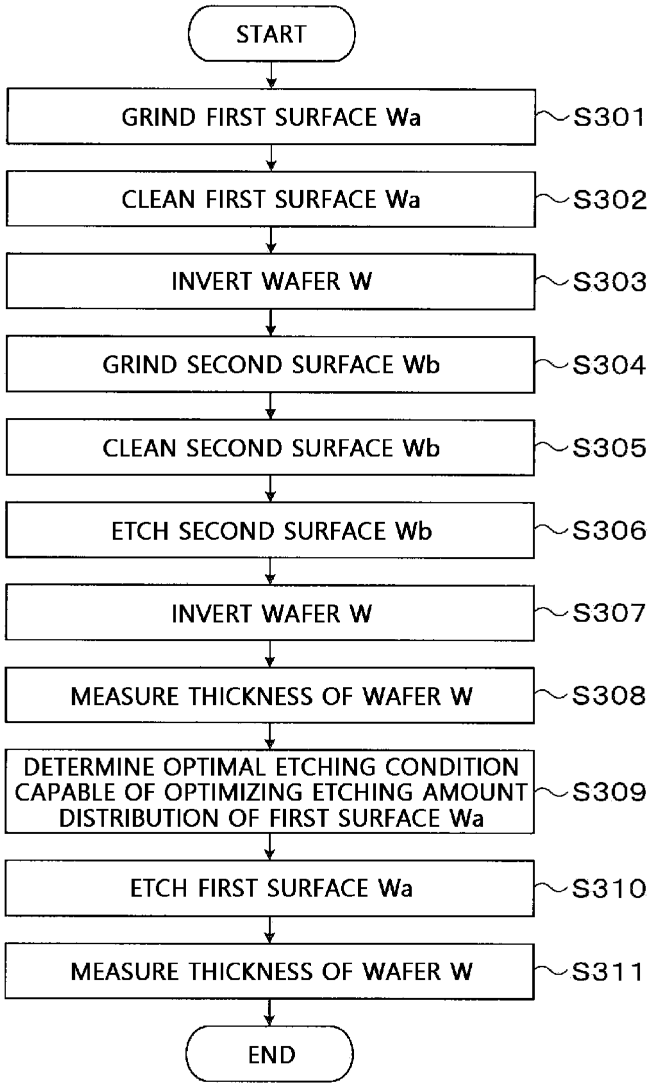
START
GRIND FIRST SURFACE Wa
S301
CLEAN FIRST SURFACE Wa
S302
INVERT WAFER W
S303
GRIND SECOND SURFACE Wb
S304
CLEAN SECOND SURFACE Wb
S305
ETCH SECOND SURFACE Wb
S306
INVERT WAFER W
S307
MEASURE THICKNESS OF WAFER W
S308
DETERMINE OPTIMAL ETCHING CONDITION CAPABLE OF OPTIMIZING ETCHING AMOUNT DISTRIBUTION OF FIRST SURFACE Wa
S309
ETCH FIRST SURFACE Wa
S310
MEASURE THICKNESS OF WAFER W
S311
END

FIG. 19A

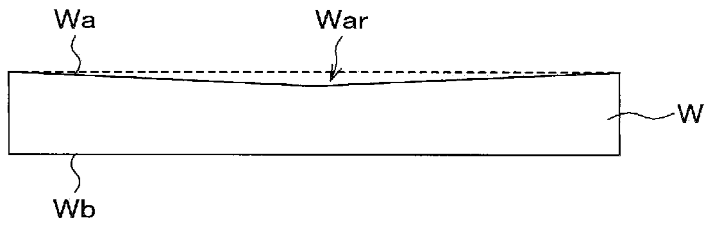


FIG. 19B

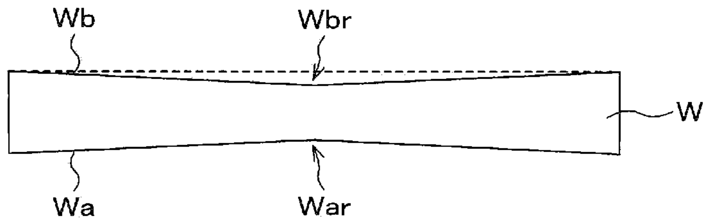


FIG. 19C

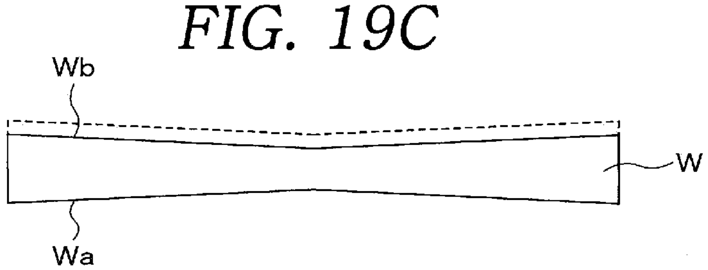


FIG. 19D

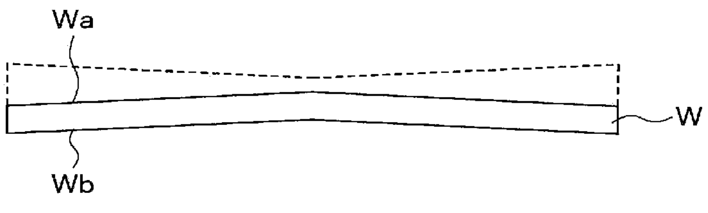

## INTERNATIONAL SEARCH REPORT

International application No.
**PCT/JP2022/037388**

**A. CLASSIFICATION OF SUBJECT MATTER**

***H01L 21/306***(2006.01)i; ***H01L 21/304***(2006.01)i
FI: H01L21/306 M; H01L21/306 R; H01L21/304 622P; H01L21/304 631; H01L21/306 B

According to International Patent Classification (IPC) or to both national classification and IPC

**B. FIELDS SEARCHED**

Minimum documentation searched (classification system followed by classification symbols)

H01L21/306; H01L21/304

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-228838 A (HITACHI HIGH-TECHNOLOGIES CORP.) 08 December 2014 (2014-12-08) paragraphs [0031]-[0055], fig. 1-8 | 1-2, 8, 12-13, 19 |
| Y | paragraphs [0031]-[0055], fig. 1-8 | 3, 6-7, 14, 17-18 |
| A | paragraphs [0031]-[0055], fig. 1-8 | 4-5, 9-11, 15-16 |
| Y | JP 11-233406 A (TOSHIBA CORP.) 27 August 1999 (1999-08-27) paragraph [0077] | 3, 14 |
| A | paragraph [0077] | 4-5, 9-11, 15-16 |
| Y | JP 2007-088402 A (SEIKO EPSON CORP.) 05 April 2007 (2007-04-05) paragraph [0009] | 3, 14 |
| A | paragraph [0009] | 4-5, 9-11, 15-16 |
| Y | JP 2018-147908 A (TOKYO ELECTRON LTD.) 20 September 2018 (2018-09-20) paragraphs [0055]-[0057] | 6-7, 17-18 |
| A | paragraphs [0055]-[0057] | 4-5, 9-11, 15-16 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 October 2022** | **20 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2022/037388**

**C. DOCUMENTS CONSIDERED TO BE RELEVANT**

| Category* | Citation of document, with indication, where appropriate, of the relevant passages | Relevant to claim No. |
|---|---|---|
| A | JP 2020-038888 A (PRE-TECH CO., LTD.) 12 March 2020 (2020-03-12) entire text, all drawings | 4-5, 9-11, 15-16 |
| A | JP 5-047737 A (KAWASAKI STEEL CORP.) 26 February 1993 (1993-02-26) entire text, all drawings | 4-5, 9-11, 15-16 |

Form PCT/ISA/210 (second sheet) (January 2015)

**INTERNATIONAL SEARCH REPORT**
**Information on patent family members**

International application No.
**PCT/JP2022/037388**

| Patent document cited in search report | Publication date (day/month/year) | Patent family member(s) | Publication date (day/month/year) |
|---|---|---|---|
| JP 2014-228838 A | 08 December 2014 | (Family: none) | |
| JP 11-233406 A | 27 August 1999 | (Family: none) | |
| JP 2007-088402 A | 05 April 2007 | (Family: none) | |
| JP 2018-147908 A | 20 September 2018 | WO 2017/018219 A1 | |
| JP 2020-038888 A | 12 March 2020 | (Family: none) | |
| JP 5-047737 A | 26 February 1993 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018147908 A